# FASCICULE DE BREVET EUROPEEN

(11) **EP 4 098 605 B1**
(45) Date de publication et mention de la délivrance du brevet: **18.12.2024**
(21) Numéro de dépôt: 22175725.5
(22) Date de dépôt: 27.05.2022
(51) Int. Cl.: B81B 3/00, B81C 99/00

(54) **MICROSYSTÈME ÉLECTROMÉCANIQUE**
ELEKTROMECHANISCHES MIKROSYSTEM
ELECTROMECHANICAL MICROSYSTEM

(30) Priorité: 31.05.2021 FR 2105640
(43) Date de publication de la demande: 07.12.2022
(73) Titulaire: Commissariat à l'Energie Atomique et aux Energies Alternatives, 75015 Paris (FR)
(72) Inventeur: MOLLARD, Laurent, 38054 GRENOBLE Cedex 09 (FR); NICOLAS, Stéphane, 38054 GRENOBLE Cedex 09 (FR); SAINT-PATRICE, Damien, 38054 GRENOBLE Cedex 09 (FR)
(74) Mandataire: Hautier IP

(56) Documents cités:
- WO-A1-2015/091836
- US-A1- 2008 212 161

## Description

### DOMAINE TECHNIQUE

La présente invention concerne le domaine des microsystèmes électromécaniques. Elle trouve par exemple pour application particulièrement avantageuse l'actionnement ou le déplacement d'objets, y compris sur des distances relativement grandes. L'invention trouve également pour application le domaine de la détection par contact. Elle pourra ainsi être mise en oeuvre pour réaliser des capteurs.

### ÉTAT DE LA TECHNIQUE

Dans des applications variées, on peut avoir besoin de déplacer des objets microscopiques, voire nanoscopiques, et/ou avoir besoin de capter des mouvements de tels objets. Il existe des microsystèmes qui permettent cela.

Lorsque ces microsystèmes sont des actionneurs, leurs performances sont évaluées notamment sur les paramètres suivants : l'amplitude du déplacement, la force déployée et la précision du déplacement généré. Lorsque ces microsystèmes sont des capteurs, leurs performances sont évaluées notamment sur leur capacité à capter un mouvement, en particulier sur une amplitude importante.

Par ailleurs, que les microsystèmes soient des actionneurs ou des capteurs, on recherche à ce qu'ils offrent de bonnes performances en termes d'encombrement, de consommation énergétique et de capacité à travailler en fréquence.

Toutes les solutions connues présentent des performances faibles pour l'un au moins de ces paramètres. Généralement, les microsystèmes existants présentent des performances trop peu satisfaisantes pour une combinaison de ces paramètres.

Par ailleurs, il est connu, du document de brevet WO 2015/091836 A1, un dispositif optique pour la stabilisation d'images comprenant des première et deuxième membranes déformables, un support de chacune des membranes, un volume constant d'un fluide enfermé entre la première et la deuxième membrane, le fluide procurant un couplage mécanique desdites première et deuxième membranes, un premier dispositif d'actionnement de la première membrane qui est configuré pour fléchir par application d'une tension électrique d'actionnement de sorte à déplacer une partie du volume de fluide, et un deuxième dispositif d'actionnement de la deuxième membrane qui est configuré pour fléchir par application d'une tension électrique d'actionnement de sorte à déplacer une partie du volume de fluide.

Le document de brevet US 2008/0212161 A1 décrit un commutateur ou interrupteur optique dans lequel un obturateur sur une membrane flexible est actionné en changeant la forme d'un liquide contenu dans un volume fermé sous la membrane.

Un objet de la présente invention est de proposer un microsystème électromécanique qui présente des performances améliorées par rapport aux solutions existantes, au moins pour l'un des paramètres mentionnés ci-dessus, ou qui présente un meilleur compromis concernant au moins deux des paramètres susmentionnés.

Un objet de la présente invention est de proposer un microsystème électromécanique permettant un double actionnement.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, selon un mode de réalisation, on prévoit un microsystème électromécanique tel que défini dans la revendication 1.

Les principaux avantages du microsystème tel qu'introduit ci-dessus sont discutés ci-dessous dans le contexte d'un déplacement d'un organe externe.

La solution proposée permet au microsystème électromécanique de former un actionneur permettant un double actionnement, et plus particulièrement un actionnement sur chacune de deux faces opposées du microsystème électromécanique, et ce en présentant, de façon aisément modulable en fonction des applications visées, une capacité suffisante en termes d'amplitude de déplacement et/ou une capacité suffisante en termes de force déployée et/ou une capacité de captation de mouvement, en particulier sur une grande amplitude, et/ou une capacité suffisante à travailler en fréquence et/ou une taille compatible avec les applications visées, et/ou une consommation en énergie réduite.

La solution proposée permet en outre au microsystème électromécanique de former un actionneur dit à grand débattement, c'est-à-dire autorisant typiquement le déplacement de l'organe externe sur une longueur de course d'au moins 30 µm, voire de 100 µm (10-6 mètres). De même, la solution proposée permet au microsystème électromécanique de former un capteur dit à grand débattement, autorisant typiquement à capter un déplacement dont l'amplitude est d'au moins 30 µm, voire de 100 µm (10-6 mètres).

Selon un exemple, la partie mobile de chaque transducteur électromécanique est de préférence configurée de sorte que sa sollicitation ou une augmentation de pression externe induise son mouvement vers l'extérieur de la cavité, et plus particulièrement à l'opposé d'au moins une paroi de la cavité différente de, de préférence opposée à, la première paroi.

En alternative à l'exemple précédent, la partie mobile de chaque transducteur électromécanique est de préférence configurée de sorte que sa sollicitation ou une diminution de pression externe induise son mouvement vers l'intérieur de la cavité et plus particulièrement en direction d'au moins une paroi de la cavité différente de, de préférence opposée à, la première paroi.

La solution proposée selon l'une et l'autre des préférences alternatives ci-dessus permet au microsystème électromécanique de former un actionneur permettant un actionnement sensiblement doublé, et plus particulièrement d'une amplitude sensiblement doublée.

Selon un exemple, le microsystème peut comprendre en outre une deuxième membrane déformable dont au moins une partie forme au moins une partie d'une paroi opposée à ladite première paroi de la cavité, ladite au moins une partie de la deuxième membrane déformable présentant au moins une zone libre de se déformer, de préférence de façon élastique, en fonction dudit changement de pression externe.

La solution proposée selon l'exemple précédent permet au microsystème électromécanique de former un double actionneur permettant un actionnement sur deux faces opposées du microsystème électromécanique.

Un autre aspect de l'invention concerne un système ou un microsystème opto-électro-mécanique comprenant au moins un microsystème électromécanique tel que défini dans la revendication 1 et au moins un microsystème optique.

Un autre exemple concerne un procédé de fabrication d'un microsystème électromécanique tel que défini dans la revendication 1, comprenant, voire étant limité à, des étapes de dépôt et de gravure ordinaires en microélectronique. Le microsystème électromécanique peut en effet être fabriqué par des moyens ordinaires de la microélectronique, ce qui confère à son fabricant tous les avantages découlant de l'utilisation de ces moyens, dont une grande latitude en termes de dimensionnement, d'énergie d'adhésion entre les différents dépôts, d'épaisseur des différents dépôts, d'étendue de gravure, etc.

Selon un exemple le procédé de fabrication du microsystème électromécanique comprend les étapes suivantes :
- une étape de formation, sur un premier substrat, d'une portion au moins du premier transducteur électromécanique et de la première membrane déformable, et
- une étape de formation, sur un second substrat, d'une portion au moins du deuxième transducteur électromécanique, puis
- une étape de formation d'une cavité ouverte sur la première membrane déformable par report du second substrat sur le premier substrat, puis
- une étape de remplissage avec le milieu déformable et de fermeture de la cavité, et
- une étape de gravure des premier et second substrats pour former, respectivement, une face avant (FAV) et une face arrière (FAR) du microsystème électromécanique.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1A est un schéma de principe d'une vue en coupe ou d'une coupe d'un microsystème électromécanique selon un premier mode de réalisation de l'invention.
La figure 1B est un schéma de principe d'une vue en coupe d'un microsystème électromécanique selon un deuxième mode de réalisation de l'invention.
La figure 1C est un schéma de principe d'une vue en coupe ou d'une coupe d'un microsystème électromécanique selon un troisième mode de réalisation de l'invention.
La figure 2A représente schématiquement une vue en coupe ou d'une coupe d'un microsystème électromécanique selon le premier mode de réalisation de l'invention.
La figure 2B représente schématiquement une vue en coupe ou d'une coupe d'un microsystème électromécanique selon le deuxième mode de réalisation de l'invention.
Les figures 3 à 6 représentent schématiquement une vue en coupe ou d'une coupe du microsystème électromécanique selon les premier et deuxième modes de réalisation de l'invention à différentes étapes du début de leur procédé de fabrication.
Les figures 7A à 10A représentent schématiquement une vue en coupe ou d'une coupe du microsystème électromécanique selon le premier mode de réalisation de l'invention à différentes étapes de la fin de son procédé de fabrication.
Les figures 7B à 10B représentent schématiquement une vue en coupe ou d'une coupe du microsystème électromécanique selon le deuxième mode de réalisation de l'invention à différentes étapes de la fin de son procédé de fabrication.
Les figures 11A et 11B représentent chacune schématiquement un microsystème opto-électro-mécanique selon un mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs des différentes couches, parois et organes illustrés ne sont pas nécessairement représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, le premier transducteur électromécanique peut s'étendre, directement ou indirectement, sur la première membrane déformable.

Selon un exemple, le premier transducteur électromécanique s'étend autour de la zone libre de la première membrane déformable. Le premier transducteur électromécanique peut présenter une forme annulaire dont le centre circulaire définit l'étendue de la zone libre de la première membrane déformable.

En alternative à l'exemple précédent, le premier transducteur électromécanique s'étend dans une zone pleine, par exemple circulaire, disjointe de la zone libre de la première membrane déformable. Le premier transducteur électromécanique peut présenter une forme annulaire.

Selon un exemple, lorsque le microsystème électromécanique comprend une deuxième membrane déformable, le deuxième transducteur électromécanique s'étend, directement ou indirectement, sur la deuxième membrane déformable.

En alternative ou en complément à l'exemple précédent :
- le deuxième transducteur électromécanique s'étend autour de la zone libre de la deuxième membrane déformable, le deuxième transducteur électromécanique pouvant présenter une forme annulaire dont le centre circulaire définit l'étendue de la zone libre de la deuxième membrane déformable ; ou
- le deuxième transducteur électromécanique s'étend dans une zone pleine, par exemple circulaire, disjointe de la zone libre de la deuxième membrane déformable, le deuxième transducteur électromécanique pouvant présenter une forme annulaire.

Selon un exemple, le premier transducteur électromécanique et le deuxième transducteur électromécanique se situent en vis-à-vis l'un de l'autre. En alternative ou en complément, la zone libre de la première membrane déformable et la zone libre de la deuxième membrane déformable se situent en vis-à-vis l'une de l'autre.

En alternative à l'exemple précédent, la zone libre de la première membrane déformable et le deuxième transducteur électromécanique se situent en vis-à-vis l'un de l'autre et la zone libre de la deuxième membrane déformable et le premier transducteur électromécanique se situent en vis-à-vis l'un de l'autre.

Le microsystème selon ces dernières caractéristiques se décline ainsi selon des géométries variées, permettant d'atteindre au moins autant de fonctionnements différents, notamment en permettant d'exploiter diverses dynamiques vibratoires.

Selon un exemple, la zone libre de chaque membrane déformable est configurée pour coopérer avec au moins un organe externe via au moins un pion fixé sur ladite zone libre, de préférence au contact de ladite zone libre et plus précisément au contact d'une face externe de la zone libre.

Le pion peut être fixé au centre de la zone libre de la membrane déformable sur laquelle il est fixé. De la sorte, l'on s'assure que le mouvement du pion est un mouvement de translation perpendiculaire à la paroi de la cavité qui est en partie formée par la membrane déformable.

Le pion peut être configuré pour coopérer avec un organe externe par l'intermédiaire d'un guide solidaire de l'organe externe, de sorte à permettre un positionnement automatique de l'organe externe sur le pion.

Chaque pion peut être configuré pour pouvoir être solidarisé avec un organe externe par collage ou magnétisme, l'énergie d'adhérence du pion sur la zone libre de la membrane déformable étant de préférence supérieure à celle du pion sur l'organe externe. Une solidarisation, éventuellement amovible, du pion et de l'organe externe est ainsi prévue qui est largement modulable en termes de force de retenue.

Chaque transducteur électromécanique peut être configuré de sorte qu'un mouvement de sa partie mobile de sa position d'équilibre à sa position hors équilibre induise un accroissement de la pression externe agissant sur le milieu déformable et chaque membrane déformable peut être configurée de sorte qu'un accroissement de la pression externe agissant sur le milieu déformable induise une déformation de la zone libre de la membrane déformable tendant à l'éloigner de la cavité (plus précisément à l'éloigner d'une paroi de la cavité opposée à la paroi formée au moins en partie d'une partie de la membrane). Le microsystème électromécanique est ainsi configuré de sorte à induire un déplacement de l'organe externe dans un premier sens, correspondant à un éloignement de l'organe externe par rapport à la cavité.

En alternative à la caractéristique précédente, chaque transducteur électromécanique peut être configuré de sorte qu'un mouvement de sa partie mobile de sa position d'équilibre à sa position hors équilibre induise une diminution de la pression externe agissant sur le milieu déformable et chaque membrane déformable peut être configurée de sorte qu'une diminution de la pression externe agissant sur le milieu déformable induise une déformation de la zone libre de la membrane déformable tendant à la rapprocher de la cavité (plus précisément à la rapprocher d'une paroi de la cavité opposée à la paroi formée au moins en partie d'une partie de la membrane). Le microsystème électromécanique est ainsi configuré de sorte à induire un déplacement de l'organe externe dans un deuxième sens, correspondant à un rapprochement de l'organe externe par rapport à la cavité.

Selon un exemple, au moins la partie mobile de chaque transducteur électromécanique peut être solidaire d'une zone de la membrane déformable sur laquelle elle s'étend, de sorte qu'un mouvement de la partie mobile du transducteur électromécanique induise un mouvement correspondant de ladite zone de la membrane déformable.

Chaque membrane déformable est de préférence configurée de sorte que sa zone libre soit capable de se déformer avec une amplitude d'au moins 50 µm, voire d'au moins 100 µm, voire d'au moins 1000 µm, selon une direction perpendiculaire au plan dans lequel elle s'étend principalement lorsqu'elle est au repos. Sans se déchirer et/ou sans usure significative, le microsystème électromécanique offre ainsi la capacité à satisfaire de nombreuses et diverses applications nécessitant un grand débattement, ce dernier étant défini le cas échéant par domaine technique concerné.

La partie mobile de chaque transducteur électromécanique peut présenter une surface au moins deux fois supérieure, voire au moins 5 fois supérieure, et de préférence au moins dix fois supérieure à une surface de la zone libre d'au moins une, voire de chaque, membrane déformable, voire à la surface des zones libres de la membrane déformable. Plus la surface du transducteur est importante par rapport à la surface de la zone libre, plus l'amplitude de déformation de la zone libre de la membrane sera importante.

Selon un exemple, le microsystème électromécanique peut comprendre en outre au moins une butée latérale configurée pour guider le mouvement d'un organe externe, lorsque la zone libre est configurée pour coopérer avec ledit organe externe de sorte que sa déformation induise, ou soit induite par, un mouvement de l'organe externe.

Ladite au moins une butée latérale peut être supportée par la paroi de la cavité qui est en partie formée par la membrane déformable. Selon un exemple optionnel, ladite butée latérale s'étend à l'opposé de la cavité.

Il est ainsi possible de :
- limiter l'inclinaison du pion lors du mouvement de la partie mobile du transducteur électromécanique, et/ou
- permettre un auto-positionnement de l'organe externe relativement à la zone libre de la membrane déformable, et/ou
- protéger la membrane déformable, et plus particulièrement sa zone libre, notamment d'un éventuel arrachement, lors d'un report ou d'un collage de l'organe externe.

Selon un exemple, lorsque la zone libre de la membrane déformable est configurée pour coopérer avec l'organe externe via un pion fixé sur ladite zone libre, le pion peut s'étendre depuis la zone libre de la membrane déformable au-delà de ladite au moins une butée latérale. En alternative, le pion peut s'étendre depuis la zone libre de la membrane déformable en-deçà de ladite au moins une butée latérale. Le microsystème électromécanique selon l'une ou l'autre de ces deux caractéristiques offre une capacité d'adaptation satisfaisante à une large variété d'organes externes et d'applications.

Au moins un, de préférence chaque transducteur électromécanique est un transducteur piézoélectrique, de préférence comprenant un matériau piézoélectrique à base de PZT.

Au moins un, de préférence chaque transducteur électromécanique peut être un transducteur à fonctionnement statique. En alternative ou en complément, au moins un, de préférence chaque transducteur électromécanique peut être un transducteur à fonctionnement vibratoire à au moins une fréquence de résonance, ladite au moins une fréquence résonance étant de préférence inférieure à 100 kHz, et encore plus préférentiellement inférieure à 1 kHz.

Le milieu déformable contenu hermétiquement dans la cavité peut comprendre au moins l'un parmi un fluide et/ou un liquide, présentant de préférence une viscosité de l'ordre de 100 cSt à température et pression ambiantes.

Selon un exemple de réalisation non limitatif, le milieu déformable présente une compressibilité comprise entre 10-9 et 10-10 Pa-1 à 20°C, par exemple de l'ordre de 10-10 Pa-1 à 20°C, sans que ces valeurs soient limitatives.

Le microsystème électromécanique tel qu'introduit ci-dessus peut comprendre en outre une pluralité de zones libres par membrane déformable.

Le microsystème électromécanique tel qu'introduit ci-dessus est de préférence exempt d'élément optique, telle qu'une lentille, notamment à focale variable.

Ledit au moins un microsystème optique du système opto-électro-mécanique tel qu'introduit ci-dessus peut comprendre au moins un miroir également désigné micro-miroir, de préférence à base de silicium.

Selon un exemple, le système opto-électro-mécanique est configuré de sorte à ce que le mouvement de la partie mobile de chaque transducteur électromécanique provoque un déplacement de l'au moins un miroir.

En alternative ou en complément, le système opto-électro-mécanique peut comprendre une pluralité de microsystèmes électromécaniques présentant chacun une zone libre agencée en vis-à-vis d'une partie d'un même microsystème optique, cette partie lui étant propre et étant de préférence un coin dudit microsystème optique. On obtient ainsi un système ou un microsystème opto-électro-mécanique bénéficiant d'une large capacité d'adaptation de son orientation optique.

On entend, par « microsystème électromécanique », un système comprenant au moins un élément mécanique et au moins un transducteur électromécanique réalisés à l'échelle micrométrique avec des moyens de la microélectronique. Le transducteur électromécanique peut capter un mouvement de l'élément mécanique ; le microsystème électromécanique joue alors le rôle de capteur. En alternative ou en complément, l'élément mécanique peut être mis en mouvement (actionné) grâce à une force générée par le transducteur électromécanique. Ce dernier peut être alimenté par des tensions électriques produites avec des circuits électroniques avoisinants.

Un « microsystème » est un système dont les dimensions externes sont inférieures à 1 centimètre (10-2 mètres) et de préférence à 1 millimètre (10-3 mètres).

Le plus souvent, un transducteur électromécanique joue un rôle d'interface entre les domaines mécanique et électrique. Toutefois, on entend ici, par « transducteur électromécanique », aussi bien un transducteur piézoélectrique qu'un transducteur thermique, ce dernier jouant un rôle d'interface entre les domaines mécanique et thermique. Un transducteur électromécanique peut comprendre une partie mobile entre une position d'équilibre, hors sollicitation, et une position hors équilibre, sous sollicitation. Lorsque le transducteur est piézoélectrique, la sollicitation est de nature électrique. Lorsque le transducteur est thermique, la sollicitation est de nature thermique.

Lorsqu'il est fait mention du centre de la cavité, ce centre est défini géométriquement en considérant comme le centre d'une cavité présentant une zone libre non déformée de la membrane déformable.

On entend par « inférieur » et « supérieur », « inférieur ou égal » et supérieur ou égal », respectivement. L'égalité est exclue par l'usage des termes « strictement inférieur » et « strictement supérieur ».

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

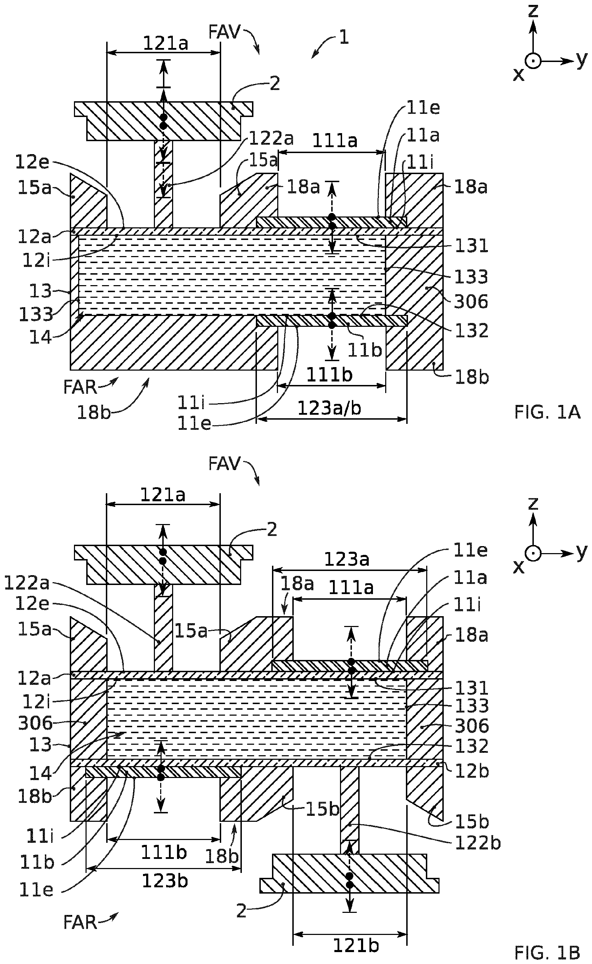

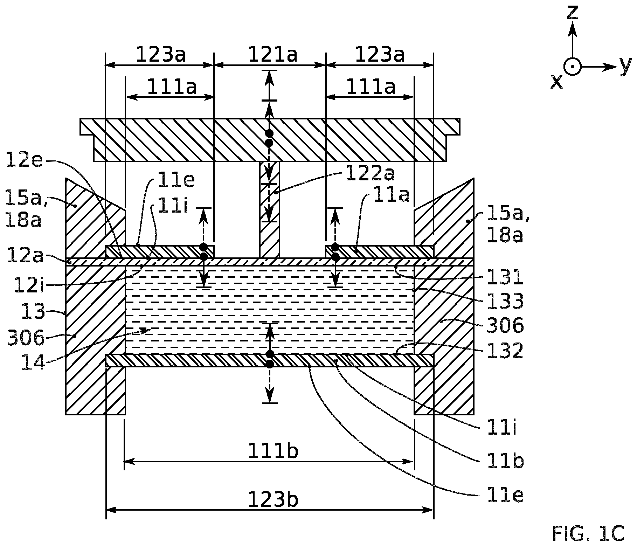

Les figures 1A, 1B et 1C sont des schémas de principe d'une vue en coupe ou d'une coupe d'un microsystème électromécanique 1 selon des premier, deuxième et troisième modes de réalisation de l'invention, respectivement. Sur chacune des figures1A à 1C sont illustrés deux transducteurs électromécaniques 11a et 11b, une première membrane déformable 12a et une cavité 13 configurée pour contenir hermétiquement un milieu déformable 14.

Chacun des schémas de principe 1A et 1B peut aussi bien représenter une structure sans symétrie de rotation ou de révolution autour d'un axe perpendiculaire et centré par rapport à la surface de la première membrane déformable 12a telle qu'illustrée, qu'une structure s'étendant, par exemple de façon sensiblement invariante, perpendiculairement à la coupe illustrée et symétrique pour une première partie par rapport à un plan perpendiculaire et centré par rapport à la zone référencée 121a et pour une deuxième partie par rapport à un plan perpendiculaire et centré par rapport à la zone référencée 111a.

Le schéma de principe 1C peut aussi bien représenter une structure avec symétrie de rotation ou de révolution autour d'un axe perpendiculaire et centré par rapport à la surface de la première membrane déformable 12a telle qu'illustrée, qu'une structure s'étendant, par exemple de façon sensiblement invariante, perpendiculairement à la coupe illustrée et symétrique par rapport à un plan perpendiculaire et centré par rapport à la zone référencée 121a.

Avant de décrire plus avant les différents modes de réalisation de l'invention illustrés sur les figures annexées, notons que chacune de ces illustrations représente schématiquement un mode de réalisation du microsystème électromécanique selon l'invention qui présente une structure traversante. Plus particulièrement, dans les différents modes illustrés, les deux transducteurs électromécaniques 11a et 11b se situent sur des faces (FAV pour face avant et FAR pour face arrière) opposées entre elles du microsystème électromécanique 1.

Chaque transducteur électromécanique 11a, 11b comprend une partie mobile 111a, 111b. Cette dernière est configurée pour se mouvoir ou être mue entre au moins deux positions. Une première de ces positions est une position d'équilibre atteinte et conservée lorsque le transducteur électromécanique 11a, 11b n'est pas sollicité, que ce soit par exemple par une tension électrique ou par une force le contraignant hors de sa position d'équilibre. Une deuxième position de la partie mobile 111a, 111b de chaque transducteur 11a, 11b est atteinte lorsque le transducteur électromécanique 11a, 11b est sollicité, que ce soit par exemple par une tension électrique ou par une force le contraignant hors de sa position d'équilibre. Chaque transducteur électromécanique 11a, 11b peut être maintenu dans l'une ou l'autre des première et deuxième positions décrites ci-dessus, et présenter ainsi un comportement binaire, ou être en outre maintenu dans n'importe quelle position intermédiaire entre sa position d'équilibre et sa position de plus grande déformation par rapport à l'équilibre.

Dans les modes de réalisation illustrés sur les figures 1A à 1C, lorsqu'un transducteur électromécanique 11a, 11b n'est pas sollicité, sa partie mobile 111a, 111b s'étend principalement dans un plan parallèle au plan xy du repère orthogonal xyz illustré sur ces figures.

Chaque transducteur électromécanique 11a, 11b est de préférence un transducteur piézoélectrique. De façon connue, un tel transducteur convertit une énergie électrique d'alimentation en un mouvement de sa partie mobile 111a, 111b de sa position d'équilibre à une position hors équilibre et/ou convertit un mouvement de sa partie mobile 111a, 111b, de sa position d'équilibre à une position hors équilibre, en un signal électrique. Il ressort donc de cet exemple, mais cela reste potentiellement vrai pour chacun des autres modes de réalisation envisagés de chaque transducteur électromécanique 11a, 11b, que le microsystème électromécanique 1 selon l'invention peut fonctionner comme actionneur et/ou comme capteur. En tant qu'actionneur, il peut permettre de déplacer un organe externe 2 vers le haut ou vers le bas, comme illustré sur les figures 1A à 1C. En tant que capteur, il peut permettre de capter un déplacement, en particulier un déplacement vertical, de l'organe externe 2 comme illustré sur les figures 1A à 1C. Ci-dessous, pour des raisons de simplicité, nous décrivons essentiellement le microsystème électromécanique 1 comme un actionneur, sans toutefois exclure sa capacité à assurer, en alternative ou en complément, une fonction de capteur.

Chaque transducteur électromécanique 11a, 11b est encore plus préférentiellement un transducteur piézoélectrique comprenant un matériau piézoélectrique à base de PZT (Titano-Zirconate de Plomb). Dans ce cas, la partie mobile 111a, 111b du transducteur électromécanique 11a, 11b est capable sous sollicitation de se mouvoir avec un déplacement plus significatif (du fait du coefficient piézoélectrique d31) qu'avec bon nombre d'autres matériaux piézoélectriques. Toutefois, le PZT étant un matériau ferroélectrique, de tels transducteurs piézoélectriques fonctionnent chacun préférentiellement dans un seul sens d'actionnement (mouvement dans un unique sens de leur partie mobile 111a, 111b) quelle que soit la polarité de son alimentation électrique, alors qu'un transducteur piézoélectrique à base d'un matériau non-ferroélectrique peut préférentiellement fonctionner dans les deux sens (mouvement dans deux sens opposés de leur partie mobile 111a, 111b). En alternative ou en complément, au moins l'un, voire chaque, transducteur électromécanique 11a, 11b peut être un transducteur piézoélectrique (non ferroélectrique) à base d'un matériau propre à permettre à sa partie mobile 111a, 111b de se mouvoir dans des sens opposés relativement à sa position d'équilibre en fonction de la polarité de son alimentation électrique. Un tel matériau est par exemple un matériau à base de nitrure d'aluminium (AIN).

En alternative ou en complément, chaque transducteur électromécanique 11a, 11b peut être ou comprendre un transducteur thermique.

La première membrane déformable 12a, ainsi que le cas échéant la deuxième membrane déformable 12b que nous introduisons plus bas, peuvent être à base d'un polymère, et est de préférence à base de PDMS. Les propriétés de la première membrane déformable 12a, et également de la deuxième, en particulier leur épaisseur, leur surface et leur forme peuvent être configurées pour conférer à la membrane déformable 12a, 12b, et plus particulièrement à une zone 121a, 121b de cette membrane qui est libre de se déformer, une capacité d'étirement escomptée, notamment en fonction de l'application visée.

La cavité 13 telle qu'illustrée notamment sur les figures 1A à 1C présente plus particulièrement des parois 131, 132, 133 contenant hermétiquement le milieu déformable 14. Dans les exemples illustrés, la paroi 132 de la cavité 13 constitue la face arrière FAR du microsystème électromécanique 1. La paroi 131 opposée à la paroi 132 est formée au moins en partie par la première membrane déformable 12a. Ainsi, la paroi 131 est déformable. La paroi 131 est parfois désignée par la suite première paroi. Elle se situe au niveau de la face avant FAV du microsystème électromécanique 1. Au moins une paroi 133 latérale joint entre elles les parois 131 et 132. Le cas échéant, la paroi 132 opposée à la paroi 131 est formée au moins en partie par une deuxième membrane déformable 12b. On notera que l'herméticité de la cavité 13 nécessite que chaque membrane déformable 12a, 12b soit elle-même imperméable, ou rendue imperméable, notamment au niveau de sa zone libre 121a, 121b.

Le milieu déformable 14 est quant à lui propre à conserver un volume sensiblement constant sous l'action d'un changement de pression externe. Autrement dit, il peut s'agir d'un milieu incompressible ou faiblement compressible dont la déformation nécessite de préférence peu d'énergie Il s'agit par exemple d'un liquide.

Du fait qu'une partie au moins de la paroi 131 de la cavité 13 est formée par la première membrane déformable 12a, l'on comprend que tout changement de pression externe exercée sur le milieu déformable 14 peut être compensé par une déformation, sensiblement proportionnelle, de la première membrane déformable 12a, et plus particulièrement de sa zone libre 121a, et/ou par un déplacement de la partie mobile 111a, 111b d'au moins un des deux transducteurs électromécaniques 11a, 11b. Lorsque l'un au moins des deux transducteurs 11a, 11b est sollicité, cette compensation est plus particulièrement liée à une conversion du changement de pression externe exercée sur le milieu déformable 14 en un étirement de la première membrane déformable 12a ou une relaxation de la première membrane déformable 12a déjà étirée. Il en va de même le cas échéant de la deuxième membrane déformable 12b.

L'on comprend que, dans un souci de reproductibilité de l'actionnement ou de la captation de mouvement qu'offre le microsystème électromécanique 1 selon l'invention, il est préférable que toute déformation de la première membrane déformable 12a soit élastique, et non plastique, pour garantir le retour dans un même état de moindre étirement, ou de relaxation maximale, de la première membrane déformable 12a chaque fois qu'elle n'est plus contrainte. A nouveau, il en va de même le cas échéant de la deuxième membrane déformable 12b.

Le milieu déformable 14 peut plus particulièrement comprendre au moins l'un parmi un fluide et/ou un liquide. Les paramètres du milieu déformable seront adaptés en fonction des applications visés. L'on s'assure ainsi que tout changement de pression externe exercée sur le milieu déformable 14 induise une déformation sensiblement proportionnelle de la zone libre 121a de la première membrane déformable 12a, et le cas échéant de la zone libre 121b de la deuxième membrane déformable 12b.

Le milieu déformable peut être constitué ou à base d'un liquide, tel que de l'huile ou peut être constitué ou à base d'un polymère. Selon un exemple, le milieu déformable est à base ou est constitué de glycérine. L'on s'assure ainsi, en plus d'une déformation sensiblement proportionnelle de chaque membrane 12a, 12b, de la capacité du milieu déformable 14 à occuper notamment le volume créé par étirement de la zone libre 121a, 121b de la membrane déformable 12a, 12b à l'opposé du centre de la cavité 13.

L'on comprend de ce qui précède que le microsystème électromécanique 1 est configuré de sorte que le mouvement de chaque transducteur électromécanique 11a, 11b soit fonction du changement de pression externe exercée sur le milieu déformable 14, pour réaliser la fonction d'actionneur du microsystème électromécanique 1, et inversement, pour réaliser la fonction de capteur du microsystème électromécanique 1. Plus particulièrement, lorsque le microsystème électromécanique 1 joue le rôle d'actionneur, au moins l'un des deux transducteurs électromécaniques 11a, 11b est sollicité de sorte à exercer un changement de pression externe sur le milieu déformable 14 et induire par-là la déformation de la première membrane déformable 12a, et le cas échéant celle de la deuxième membrane déformable 12b. Lorsque le microsystème électromécanique 1 comprend une seule membrane déformable, par exemple la première membrane déformable 12a, et joue le rôle de capteur, la déformation de la première membrane déformable 12a, exerce un changement de pression externe sur le milieu déformable 14 qui peut induire un déplacement de la partie mobile 111a, 111b des transducteurs électromécaniques 11a, 11b.

Comme illustré sur chacune des figures 1A à 1C, le microsystème électromécanique 1 peut être tel que la zone libre 121a de la première membrane déformable 12a est configurée pour coopérer avec un organe externe 2. De la sorte, la déformation de la zone libre 121a induit, ou est induite par, un mouvement de l'organe externe 2. Il peut en être de même de la zone libre 121b de la deuxième membrane 12b.

C'est donc par l'intermédiaire de la zone libre 121a de la première membrane 12a, et le cas échéant par l'intermédiaire de la zone libre 121b de la deuxième membrane 12b, que le microsystème électromécanique 1 déplace un organe externe 2.

Ainsi, lorsque le microsystème électromécanique 1 joue le rôle d'actionneur, l'activation d'un des transducteurs électromécaniques 11a, 11b déforme la première membrane 12a, et le cas échéant la deuxième membrane 12b, ce qui déplace l'organe 2, voire chaque organe 2 agencé conjointement avec une des zones libres 121a et 121b.

Inversement, lorsque le microsystème électromécanique 1 joue le rôle de capteur, un appui d'un organe externe 2 sur l'unique première membrane 12a ou une traction de la première membrane 12a par un organe externe 2, déforme la membrane 12a, ce qui déplace les parties mobiles des transducteurs électromécaniques 11a, 11b puis génère in fine un signal qui est fonction de ce déplacement.

Plus particulièrement, comme illustré sur les figures 1A et 1C, la coopération entre la zone libre 121a de la première membrane déformable 12a et l'organe externe 2 peut être réalisée via un pion 122a fixé sur la zone libre 121a. En outre, comme illustré sur la figure 1B, la coopération entre la zone libre 121a, 121b de chaque membrane déformable 12a, 12b et chaque organe externe 2 peut être réalisée via un pion 122a, 122b fixé sur la zone libre 121a, 121b, respectivement.

Comme illustré sur chacune des figures 1A et 1C, le pion 122a peut être plus particulièrement fixé au centre de la zone libre 121a de la première membrane déformable 12a, ou être plus généralement fixé symétriquement par rapport à l'étendue de la zone libre 121a de la première membrane déformable 12a. De la sorte, le pion 122a est déplacé, par la déformation élastique de la zone libre 121a, dans un sens contrôlé, sensiblement vertical, et n'est pas, ou peu, incliné par rapport à la verticale lors de ses déplacements. Le débattement latéral du pion 122a est ainsi avantageusement limité. Il en va de même de la zone libre 121b de la deuxième membrane 12b et du pion 122b fixé sur la zone libre 121b.

En complément ou en alternative, chaque organe externe 2 peut être structuré de sorte à comprendre un guide par lequel l'organe externe 2 est destiné à coopérer avec le pion 122a, 122b. Ce guide peut lui aussi contribuer à s'opposer à une inclinaison du pion 122a, 122b lors de ses déplacements. Nous verrons plus tard que les limitations ainsi atteintes en termes de débattement latéral du pion 122a, 122b peuvent encore être renforcées par la présence d'au moins une butée latérale 15a, 15b s'étendant depuis une partie de la paroi 131, 132 autour de la zone libre 121a, 121b de la membrane déformable 12a, 12b.

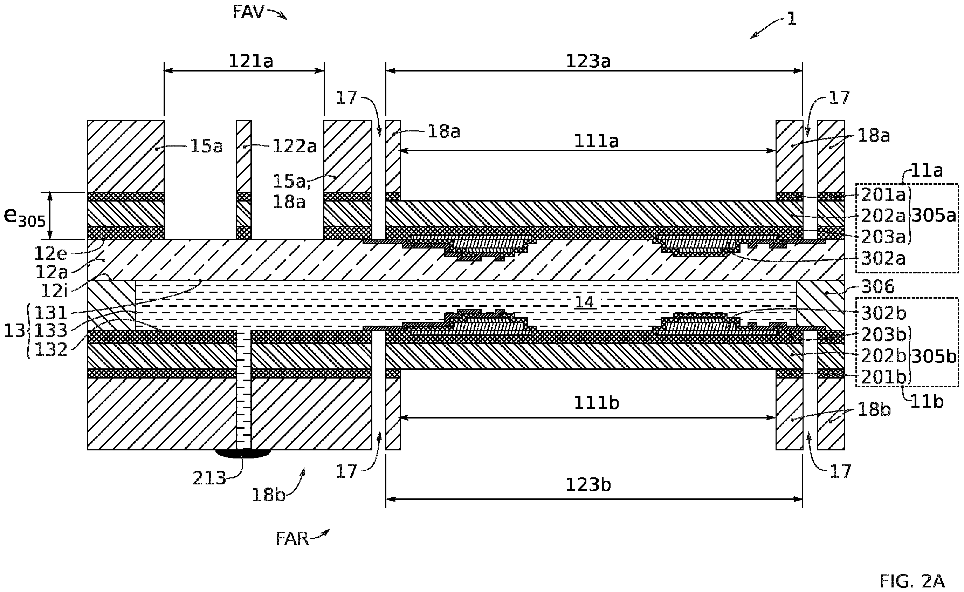

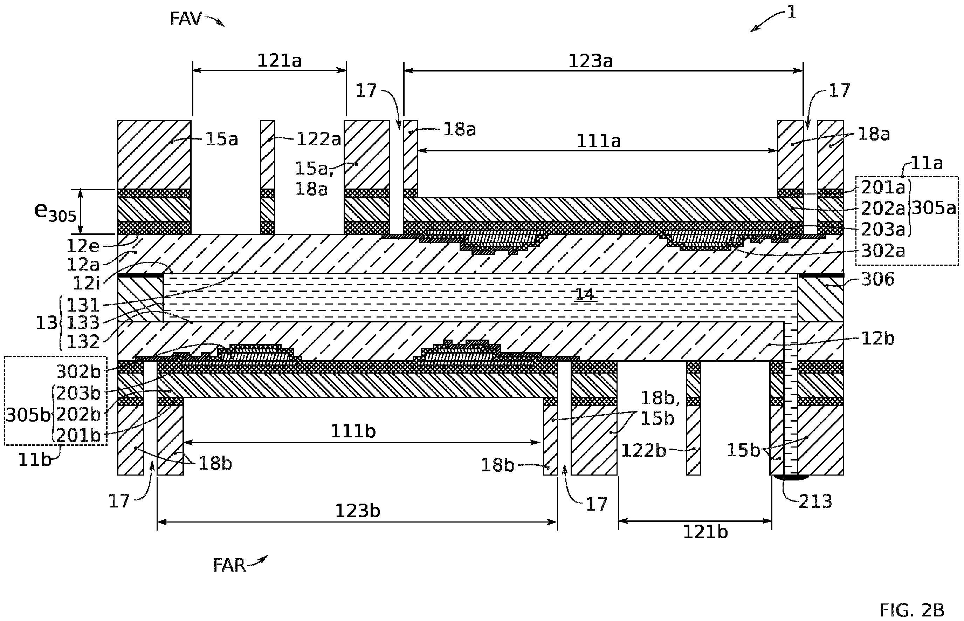

De façon non limitative, un collage ou une aimantation du pion 122a, 122b sur l'organe externe 2 peut permettre de solidariser entre eux le pion 122a, 122b et l'organe externe 2. L'énergie d'adhérence du pion 122a, 122b sur la zone libre 121a, 121b de la membrane déformable 12a, 12b est de préférence supérieure à celle du pion 122a, 122b sur l'organe externe 2. Nous verrons, lorsque nous décrirons les procédés de fabrication des microsystèmes électromécaniques 1 illustrés sur les figures 2A et 2B que l'énergie d'adhérence du pion 122a, 122b sur la zone libre 121a, 121b peut être une résultante d'étapes technologiques ordinaires dans le domaine de la micro-électronique. Cette énergie d'adhérence pouvant ainsi être estimée ou mesurée, il est aisé d'obtenir par collage, par exemple à l'aide d'une résine ad hoc, ou par aimantation, par exemple une solidarisation qui soit d'une énergie plus faible que l'énergie avec laquelle le pion 122a, 122b est solidarisé avec la membrane déformable 12a, 12b. On comprend donc que la solidarisation du pion 122a, 122b avec un organe externe 2 est ainsi largement modulable en termes de force de retenue. Cette modularité peut permettre notamment de rendre amovible la solidarisation entre le pion 122a, 122b et l'organe externe 2, par exemple pour permettre à un même microsystème électromécanique 1 selon l'invention d'être agencé successivement avec plusieurs organes externes 2, voire plusieurs pluralité d'organes externes 2, avec chacun desquels il serait solidarisé, puis désolidarisé.

Comme illustré sur chacune des figures 1A à 1C, le premier transducteur électromécanique 11a forme une partie de la première paroi 131 de la cavité 13. Le premier transducteur électromécanique 11a et la première membrane déformable 12a sont ainsi placés d'un même côté de la cavité 13.

Comme illustré sur chacune des figures 1Aà 1C, la première membrane 12a présente une face interne 12i configurée pour être au contact du milieu déformable 14 et une face externe 12e. La face interne 12i forme au moins une partie de la paroi 131 de la cavité 13. Le premier transducteur électromécanique 11a présente une face interne 11i tournée au regard, et de préférence au contact de la face externe 12e de la première membrane 12a. Le premier transducteur électromécanique 11a présente également une face externe 11e, opposée à la face interne 11i, et tournée vers l'extérieur du microsystème électromécanique 1. Alternativement, on peut prévoir qu'une ou des couches intermédiaires soient disposées entre la face externe 12e de la membrane 12 et la face interne 11i du premier transducteur 12a.

Le microsystème électromécanique 1 est configuré de sorte que le mouvement de la partie mobile 111a du premier transducteur électromécanique 11a provoque un déplacement de la première membrane 12a et donc de la première paroi 131 qui enferme le milieu 14.

On remarquera que :
- le premier transducteur électromécanique 11a s'étend sur la première membrane déformable 12a, soit en définissant la zone libre 121a de la première membrane déformable 12a comme illustré sur la figure 1C, soit en s'étendant dans une zone pleine, par exemple circulaire, disjointe de la zone libre 121a de la première membrane déformable 12a comme illustré sur les figures 1A et 1B, et
- la première membrane déformable 12a sépare le premier transducteur électromécanique 11a du milieu déformable 14.

Comme illustré sur chacune des figures 1A à 1C, le deuxième transducteur électromécanique 11b présente une face interne 11i et une face externe 11e, opposée à la face interne 11i et tournée vers l'extérieur du microsystème électromécanique 1.

Comme illustré sur la figure 1B, la deuxième membrane 12b présente une face interne 12i configurée pour être au contact du milieu déformable 14 et une face externe 12e. La face interne 12i forme une partie de la paroi 132 de la cavité 13 opposée à la première paroi 131 ; dans l'absolu, elle pourrait alternativement formée une partie de la paroi 133 de la cavité 13. La face interne 11i du deuxième transducteur électromécanique 11b est tournée au regard, et de préférence au contact de la face externe 12e de la deuxième membrane 12b. Alternativement, on peut prévoir qu'une ou des couches intermédiaires soient disposées entre la face externe 12e de la deuxième membrane 12b et la face interne 11i du deuxième transducteur 12b.

Le microsystème électromécanique 1 selon son mode de réalisation illustré sur la figure 1B est configuré de sorte que le mouvement de la partie mobile 111b du deuxième transducteur électromécanique 11b provoque un déplacement de la première membrane 12a et de la deuxième membrane 12b et donc des parois 131 et 132 qui enferment le milieu 14.

On remarquera que, sur la figure 1B :
- Le deuxième transducteur électromécanique 11b s'étend sur la deuxième membrane déformable 12b en s'étendant dans une zone pleine, par exemple circulaire, disjointe de la zone libre 121b de la deuxième membrane déformable 12b ; il pourrait en alternative s'étendre sur la deuxième membrane déformable 12b autour la zone libre 121b de la membrane déformable 12b, et définir ainsi cette dernière, et
- La deuxième membrane déformable 12b sépare le deuxième transducteur électromécanique 11b du milieu déformable 14.

En outre, chaque transducteur électromécanique 11a, 11b peut avantageusement être solidaire de la membrane déformable 12a, 12b sur une zone 123a, 123b sur laquelle il s'étend, de sorte que tout mouvement de la partie mobile 111a, 111b du transducteur électromécanique 11a, 11b induise, notamment sur cette zone 123a, 123b, un étirement ou une relaxation de la membrane déformable 12a, 12b. Ainsi, lorsque au moins un des transducteurs électromécaniques 11a, 11b est sollicité de sorte à se déplacer vers l'extérieur de la cavité (comme illustré par les flèches en tirets s'étendant depuis la partie mobile 111a, 111b de chaque transducteur électromécanique 11a, 11b), une diminution de la pression externe exercée sur le milieu déformable 14 est observée, qui induit l'étirement de la première membrane déformable 12a, et le cas échéant de la deuxième membrane déformable 12b, vers le centre de la cavité 13.

Notons ici que cette solidarisation entre chaque transducteur électromécanique 11a, 11b et la membrane déformable 12a, 12b sur laquelle il s'étend n'est que préférentielle pour le microsystème électromécanique 1, notamment dans la mesure où la partie mobile 111a, 111b de chaque transducteur électromécanique 11a, 11b peut être destinée à appuyer sur la membrane déformable 12a, 12b sur laquelle il s'étend lorsque le transducteur électromécanique 11a, 11b est sollicité et/ou dans la mesure où la membrane déformable 12a, 12b peut avoir naturellement tendance à rester au contact de la partie mobile 111a, 111b du transducteur électromécanique 11a, 11b qui s'étend sur celle-ci lorsque ce dernier n'appuie pas sur la membrane déformable 12.

En référence aux figures 1A à 1C, un premier capot 18a peut être prévu qui est configuré, et qui est plus particulièrement suffisamment rigide, pour maintenir la première membrane 12a au moins autour de sa zone libre 121a et/ou autour de la zone 123a sur laquelle s'étend le premier transducteur 11a. La première membrane 12a est ainsi située entre le premier capot 18a et le milieu déformable 14. Ce premier capot 18a s'étend par exemple principalement dans le plan xy. Il présente au moins une ouverture qui définit la zone 123a. Il peut présenter en outre une ouverture qui définit la zone libre 121a (Cf. figures 1A et 1B). Le premier capot 18a peut s'étendre sur toute la surface de la cavité 13, en projection sur le plan xy, à l'exception d'au moins une ouverture définissant l'ouverture 123a et/ou l'ouverture 121a. Comme illustré sur les figures 1A et 1B, le premier capot 18a peut présenter une zone qui sépare ces deux ouvertures 123a et 121a.

En référence aux figures 1A à 1C, un deuxième capot 18b peut être prévu qui est :
- configuré pour définir, comme illustré sur les figures 1A et 1C, au moins une ouverture 123b sur laquelle s'étend le deuxième transducteur 11b, et
- configuré, et plus particulièrement suffisamment rigide, pour maintenir, comme illustré sur la figure 1B, la deuxième membrane 12b au moins autour de sa zone libre 121b. La deuxième membrane 12b est ainsi située entre le deuxième capot 18b et le milieu déformable 14.

Ce deuxième capot 18b s'étend par exemple principalement dans le plan xy. Il présente au moins une ouverture qui définit la zone 123b. Il peut présenter en outre une ouverture qui définit la zone libre 121b de la deuxième membrane 12b (Cf. figure 1B). Le deuxième capot 18b peut s'étendre sur toute la surface de la cavité 13, en projection sur le plan xy, à l'exception d'au moins une ouverture définissant l'ouverture 123b et le cas échéant l'ouverture 121b. Comme illustré sur la figure 1B, le deuxième capot 18b peut présenter une zone qui sépare ces deux ouvertures 123b et 121b.

La figure 1A illustre schématiquement un premier mode de réalisation du microsystème 1 selon l'invention. Ce mode de réalisation peut comprendre une unique membrane déformable dite première membrane déformable et référencée 12a. Il comprend en outre les deux transducteurs électromécaniques 11a et 11b.

Les deux transducteurs 11a et 11b peuvent être configurés de sorte que leur sollicitation ou une diminution de pression externe subie par le milieu déformable 14 induise leur mouvement vers l'intérieur de la cavité 13, comme illustré par les flèches en trait plein sur la figure 1A.

En alternative, les deux transducteurs 11a et 11b sont configurés de sorte que leur sollicitation ou une augmentation de pression externe subie par le milieu déformable 14 induise leur mouvement vers l'extérieur de la cavité 13, comme illustré par les flèches en tirets sur la figure 1A.

Les deux transducteurs 11a et 11b peuvent chacun prendre la forme d'un disque de rayon R, par exemple égale à 200 microns. D'autres formes sont également envisageables. En outre, les deux transducteurs 11a et 11b peuvent présenter des dimensions différentes entre elles.

Le premier transducteur 11a forme une partie de la première paroi 131 de la cavité 13. Rappelons que cette première paroi 131 est au moins en partie formée par la première membrane 12a. On remarque que la zone libre 121a de la première membrane 12a est décentrée relativement au premier transducteur 11a. Plus particulièrement, le premier transducteur 11a s'étend dans une zone pleine, par exemple circulaire, disjointe de la zone libre 121a de la première membrane déformable 12a.

Comme illustré par les flèches en trait plein et en tirets, les deux transducteurs 11a et 11b sont de préférence configurés pour se mouvoir dans un même sens relativement au centre de la cavité 13.

Le deuxième transducteur 11b forme une partie de la paroi 132 opposée à la première paroi 131 de la cavité 13. Le deuxième transducteur 11b pourrait en alternative former une partie de la paroi 133 joignant entre elles les parois 131 et 132 de la cavité 13.

Plus particulièrement, sur la figure 1A, le deuxième transducteur 11b peut être situé en vis-à-vis du premier transducteur 11a. En alternative, le deuxième transducteur 12b pourrait être situé en vis-à-vis de la zone libre121a de la première membrane déformable 12a.

Lorsque l'un des deux transducteurs 11a et 11b est sollicité, il provoque une déformation de la zone libre 121a de la première membrane 12a qui induit le déplacement de l'organe externe 2. Lorsque l'autre des deux transducteurs 11a et 11b est également sollicité, il provoque une déformation accrue de la zone libre 121a de la première membrane 12a qui induit sensiblement un doublement du déplacement de l'organe externe 2.

Par exemple, la surface de la zone libre 121a de la première membrane 12a est inférieure, et plus particulièrement deux fois inférieure, voire dix fois inférieure, à la surface sur laquelle s'étend chacun des deux transducteurs 11a et 11b.

La figure 1B illustre un deuxième mode de réalisation du microsystème 1 selon l'invention. Ce mode de réalisation comprend les deux membranes déformables 12a et 12b susmentionnées. Une comparaison des modes de réalisation illustrée sur les figures 1A et 1B montre que leurs parties supérieures, situées au-dessus d'un plan perpendiculaire à l'axe z et passant par le centre de la cavité 13, sont identiques entre elles. Nous renvoyons au descriptif de la figure 1A pour ce qui concerne la partie supérieure de la figure 1B.

En outre, on observe sur la figure 1B que la partie inférieure de cette figure et symétrique à sa partie supérieure par rotation de 180° autour du centre de la cavité 13. En alternative, une symétrie par rapport à un plan perpendiculaire à l'axe z et passant par le centre de la cavité 13 entre les parties inférieure et supérieure est envisageable.

Lorsque l'un des deux transducteurs 11a et 11b est sollicité, il provoque une déformation de chacune des zones libres 121a et 121b des première et deuxième membranes 12a et 12b qui induit le déplacement de chacun des organes externes 2 situés de part et d'autre du microsystème électromécanique 1. Lorsque l'autre des deux transducteurs 11a et 11b est également sollicité, il provoque une déformation accrue des zones libres 121a et 121b des première et deuxième membranes 12a et 12b qui induit sensiblement un doublement du déplacement des organes externes 2.

Les organes externes 2 peuvent être joints entre eux pour former une structure fixe ou articulée. Dès lors l'on comprend que le microsystème 1 selon le deuxième mode de réalisation de l'invention peut permettre la préhension d'une telle structure et/ou l'exercice sur une telle structure d'un effort d'écartement ou de poussée (notamment dans le cas d'une symétrie entre parties supérieure et inférieure du microsystème 1 par rapport à un plan perpendiculaire à l'axe z et passant par le centre de la cavité 13).

Par exemple, la surface de chaque zone libre 121a, 121b des première et deuxième membranes 12a, 12b est au moins deux fois inférieure, et plus particulièrement quatre fois inférieure, voire dix fois inférieure, à la surface sur laquelle s'étend chacun des deux transducteurs 11a et 11b.

Notons en outre que les zones libres 121a et 121b des première et deuxième membranes 12a, 12b peuvent présenter des formes et/ou des dimensions différentes entre elles.

La figure 1C illustre un troisième mode de réalisation du microsystème 1 selon l'invention. Ce mode de réalisation comprend une première membrane déformable 12a dont la zone libre 121a est centrée par rapport au premier transducteur 11a. Le deuxième transducteur 11b est plus particulièrement situé en vis-à-vis du premier transducteur 11a, de sorte que le microsystème 1 peut présenter une symétrie de révolution, voire de rotation, autour d'un axe orienté selon l'axe z et passant par le centre de la cavité 13, ou une symétrie par rapport à un plan perpendiculaire à l'axe y est passant par le centre de la cavité.

Lorsque l'un des deux transducteurs 11a et 11b est sollicité, il provoque une déformation de la zone libre 121a de la première membrane 12a qui induit le déplacement de l'organe externe 2. Lorsque l'autre des deux transducteurs 11a et 11b est également sollicité, il provoque une déformation accrue de la zone libre121a de la première membrane 12a qui induit sensiblement un doublement du déplacement de l'organe externe 2.

En alternative au mode de réalisation illustré sur la figure 1C, un mode de réalisation envisageable vient en considérant un microsystème 1 dont la partie supérieure serait identique à celle illustrée sur la figure 1C et dont la partie inférieure serait obtenue par symétrie de cette partie supérieure par rapport à un plan perpendiculaire à l'axe z et passant par le centre de la cavité 13. Un tel mode de réalisation comprendrait ainsi deux membranes déformables et deux transducteurs électromécaniques entourant chacun une zone libre d'une respective des deux membranes déformables. Potentiellement, un tel mode de réalisation permettrait de déplacer deux organes externes 2.

Notons que le mode de réalisation illustré sur la figure 1C offre les mêmes avantages que celui illustré sur la figure 1A, et est avantageusement plus compact.

La figure 1C illustre le recouvrement partiel de la première membrane déformable 12a par le premier transducteur électromécanique 11a. Le premier transducteur électromécanique 11a peut y prendre la forme d'un anneau d'étendue radiale notée R2 et définit une zone libre 121a circulaire de rayon noté R1.

Notons que le premier transducteur électromécanique 11a peut ne pas être limité à une forme annulaire, mais peut prendre d'autres formes, et notamment une forme oblongue ou ovale, une forme triangulaire rectangulaire, etc. définissant une pluralité correspondante de formes de la zone libre 121a de la première membrane déformable 12a.

Cette description de la figure 1C vaut en particulier pour une structure à symétrie de rotation ou de révolution. Néanmoins, la figure 1C peut aussi être vue comme illustrant une structure symétrique par rapport à un plan perpendiculaire et centré par rapport à la surface de la zone libre 121a ; une telle structure consisterait notamment en trois bandes adjacentes deux à deux dont la bande centrale représenterait la zone libre 121a de la première membrane déformable 12a et dont les bandes latérales représenteraient la partie mobile du premier transducteur électromécanique 11a.

Notamment lorsque le recouvrement partiel de la première membrane déformable 12a par le premier transducteur électromécanique 11a est tel qu'illustré sur les figures 1A à 1C et que le premier transducteur électromécanique 11a est un transducteur piézoélectrique comprenant un matériau piézoélectrique à base de PZT, il est intéressant que la partie mobile 111a du transducteur électromécanique 11a présente une surface au moins deux fois, voire au moins quatre fois, voire au moins dix fois, supérieure à la surface de la zone libre 121a de la première membrane déformable 12a. La première membrane déformable 12a peut dès lors être configurée de sorte que sa zone libre 121a est capable de se déformer avec une amplitude d'au moins 50 µm, d'environ 100 µm, voire de plusieurs centaines de microns, sous sollicitation d'un des deux transducteurs 11a et 11b, ou alternativement sous sollicitation des deux transducteurs 11a et 11b.

De manière générale, la première membrane déformable 12a est de préférence configurée de sorte que sa zone libre 121a est capable de se déformer avec une amplitude inférieure à 1 mm.

L'amplitude de déformation de chaque zone libre 121a, 121b est mesurée selon une direction perpendiculaire au plan dans lequel s'étend principalement la face externe 12e de la première membrane 12a, et le cas échéant de la deuxième membrane 12b, au repos.

Sans se déchirer et/ou sans usure significative, le microsystème électromécanique 1 permet une amplification hydraulique de l'action et offre ainsi la capacité à satisfaire de nombreuses et diverses applications nécessitant un grand débattement. Dans ce contexte, le microsystème électromécanique 1 illustré sur les figures 1A à 1C peut être défini comme un actionneur à grand débattement ascendant ou descendant.

Egalement lorsque le recouvrement partiel de la première membrane déformable 12a par le premier transducteur électromécanique 11a est tel qu'illustré sur les figures 1A et 1B et que le premier transducteur électromécanique 11a est un transducteur piézoélectrique comprenant un matériau piézoélectrique à base de PZT, le rayon R1 de la zone libre 121a de la première membrane déformable 12a peut être sensiblement égal à 100 µm et le rayon R2 du premier transducteur électromécanique 11a peut être sensiblement égal à 350 µm.

Lorsque le recouvrement partiel de la première membrane déformable 12 par le premier transducteur électromécanique 11a est tel qu'illustré sur les figures 1A et 1B et que le premier transducteur électromécanique 11a est un transducteur piézoélectrique comprenant un matériau piézoélectrique à base de PZT, mais en référence aux figures 2A et 2B discutées plus en détails ci-dessous, le premier transducteur électromécanique 11a comprend plus particulièrement un élément constituant une poutre 305a et un élément piézoélectrique 302a à base de PZT, ce dernier étant configuré pour induire une déformation de la poutre 305a. L'épaisseur de l'élément piézoélectrique 302a peut être sensiblement égale à 0,5 µm et l'épaisseur de la poutre 305a est par exemple comprise entre quelques microns et plusieurs dizaines de microns, par exemple 5 µm. Dans une telle configuration, la partie mobile 111a du premier transducteur électromécanique 11a peut être déplacée ou défléchie avec une amplitude sensiblement égale à 15 µm en étant parcourue par une tension électrique égale à quelques dizaines de volt.

L'invention n'est toutefois pas limitée aux différentes valeurs spécifiques données ci-dessus qui peuvent être largement adaptées, en fonction de l'application visée, notamment pour trouver un compromis entre facteur d'étirement et amplitude de déformation attendue de la zone libre 121 de la membrane déformable 12.

A noter que, dans sa position d'équilibre, la partie mobile 111a du premier transducteur électromécanique 11a, et plus généralement le premier transducteur électromécanique 11a, peut ne pas être plat, mais peut au contraire présenter une déflexion, dite à l'équilibre, qui n'enlève rien, en termes d'amplitude, à la capacité de déplacement ou de déflection du premier transducteur électromécanique 11a alimenté électriquement.

Notons que, notamment lorsque l'un au moins des deux transducteurs électromécaniques 11a et 11b est un transducteur piézoélectrique, il peut avantageusement être un transducteur à fonctionnement vibratoire. Sa fréquence de résonance est alors de préférence inférieure à 100 kHz, et encore plus préférentiellement inférieures à 1 kHz. La dynamique vibratoire ainsi obtenue peut permettre d'atteindre des débattements plus grands qu'en fonctionnement statique, notamment en exploitant le phénomène de résonnance afférent ou de diminuer la consommation du microsystème électromécaniques pour un débattement donné. On comprend que, en fonction du degré de symétrie des modes de réalisation décrits et envisagés ci-dessus en référence aux figures 1A à 1C, diverses dynamiques vibratoires puissent être obtenues pour une diversité correspondante d'applications.

Comme déjà mentionné plus haut, le microsystème électromécanique 1 peut comprendre en outre une ou plusieurs butées latérales 15 supportées par la première paroi 131 de la cavité 13 et/ou la paroi 132 opposée à la première paroi 131 de la cavité 13. Chaque butée latérale 15 s'étend plus particulièrement à l'opposé de la cavité 13. Par exemple, une butée latérale 15 peut contribuer à mettre en prise la partie non mobile d'un transducteur, pour mieux s'assurer de son immobilité ; elle s'étend alors depuis la partie non mobile du transducteur 11a, 11b et/ou à distance de sa partie mobile 111a, 111b, et se confond alors avec le capot 18a, 18b remplissant cette même fonction.

Ainsi, une butée latérale 15 peut avoir, comme le capot 18a, 18b, une action de maintien en position d'une partie non mobile d'un transducteur électromécanique 11a, 11b, ladite partie non mobile étant complémentaire de la partie mobile 111a, 111b du transducteur électromécanique 11a, 11b. En ce sens, chaque butée latérale 15 se confond avec un des capots 18a et 18b. Par exemple, comme illustré sur la figure 2A, l'action de maintien de la partie non mobile du premier transducteur électromécanique 11a peut plus particulièrement être assurée par sa mise en prise par une butée latérale 15 et/ou le capot 18a située en périphérie de la zone 123a sur laquelle s'étend le premier transducteur électromécanique 11a et l'action de maintien de la partie non mobile du deuxième transducteur électromécanique 11b peut plus particulièrement être assurée par sa mise en prise par une butée latérale 15 et/ou le capot 18b en périphérie de la zone 123b sur laquelle s'étend le deuxième transducteur électromécanique 11b. En outre, afin d'améliorer le maintien procuré par de telles butées latérales 15 et/ou de tels capots 18a et 18b, chaque espaceur 306, tel que décrit ci-dessous, s'étend de préférence vers la partie centrale du microsystème 1 au moins jusqu'au droit de la première butée latérale et/ou du capot, de sorte à concourir au maintien de la partie non mobile d'un transducteur électromécanique.

Relativement aux butées latérales 15, le pion 122 peut s'étendre, à l'opposé de la cavité 13, au-delà ou en deçà.

Les butées latérales 15a, 15b sont principalement configurées pour permettre le guidage et l'autopositionnement de l'organe externe 2 sur le microsystème électromécanique 1. Elle contribue encore à limiter, voire à annihiler, le risque d'arrachement de la membrane déformable 12a, 12b lors du report de l'organe externe 2 sur le microsystème électromécanique 1. Notons ici que, dépendant de l'étendue de l'organe externe 2, les butées latérales 15a, 15b peuvent également jouer le rôle de butée haute limitant le rapprochement de l'organe externe 2 vers le microsystème électromécanique 1. Cette particularité peut également permettre d'induire une désolidarisation du pion 122a, 122b et de l'organe externe 2 entre eux en tirant le pion 122a, 122b dans une position plus basse que celle possiblement atteinte par l'organe externe 2 du fait que ce dernier bute sur le haut des butées latérales 15a, 15b. Plus précisément, les butées latérales 15a, 15b présentent une surface de butée configurée pour stopper le déplacement de l'organe 2. Le microsystème électromécanique 1 est configuré de sorte à ce que lorsque le déplacement de l'organe 2 est stoppé dans son déplacement, selon un sens donné, par les butées latérales 15a, 15b, le pion 122a, 122b peut poursuivre son déplacement, dans ce même sens. Le pion 122a, 122b se désolidarise ainsi de l'organe 2.

Des modes de réalisation de l'invention plus spécifiques que ceux décrits ci-dessus sont illustrés sur les figures 2A et 2B sur lesquelles les mêmes références que sur les figures 1A et 1B référencient les mêmes objets.

On y observe tout d'abord que chaque transducteur électromécanique 11a, 11b illustré comprend une poutre 305a, 305b et un matériau piézoélectrique 302a, 302b configuré pour déformer la poutre 305a, 305b lorsqu'il est soumis à une tension électrique.

On remarque, sur les figures 2A et 2B, que le matériau piézoélectrique 302a, 302b de chaque transducteur 11a, 11b est situé vers l'intérieur de la cavité 13, tandis que la poutre 305a, 305b de chaque transducteur 11a, 11b est située vers l'extérieur de la cavité 13. C'est cette caractéristique qui permet d'obtenir des déformations antagonistes entre elles des poutres 305a, 305b. C'est ainsi que la déformation d'une des deux poutres 305a, 305b induit un même effet, ici une augmentation, de la pression externe sur le milieu déformable 14, que la déformation de l'autre des deux poutres.

Les modes de réalisation spécifiques illustrés sur les figures 2A et 2B correspondent plus particulièrement aux modes de réalisation illustrés sur les figures 1A et 1B dont les déformations sont représentées par des flèches en trait plein.

Comme indiqué sur la figure 1A par les flèches en tirets, il est également envisageable que les transducteurs 11a, 11b soient configurés pour se déformer dans des sens opposés relativement aux modes de réalisation spécifiques illustrés sur les figures 2A et 2B. Auquel cas, le matériau piézoélectrique 302a, 302b de chaque transducteur 11a, 11b serait situé vers l'extérieur de la cavité 13, tandis que la poutre 305a, 305b de chaque transducteur 11a, 11b serait située vers l'intérieur de la cavité 13.

Il apparaîtra clairement au vu de la description ci-dessous des procédés de fabrication des microsystèmes 1 tels qu'illustrés sur les figures 2A et 2B que l'une et l'autre des dispositions décrites ci-dessus des matériaux piézoélectrique 302a et 302b relativement aux poutres 305a et 305b, et plus généralement relativement aux fibres neutres des transducteurs électromécaniques 11a et 11b, peuvent être aisément obtenues par des étapes de dépôt et de gravure pouvant être qualifiées comme ordinaires dans le domaine de la microélectronique.

On remarque également que, si les deux transducteurs 11a et 11b peuvent chacun prendre la forme d'un disque de rayon R, chaque matériau piézoélectrique 302a, 302b peut prendre la forme d'un anneau. L'étendue radiale de l'anneau formé par chaque matériau piézoélectrique 302a, 302b est par exemple comprise entre 10 et 1000 microns, et typiquement sensiblement égale à 200 microns. En alternative, et comme mentionné plus haut, il est également envisagé que les matériaux piézoélectriques 302a et 302b forment des bandes s'étendant perpendiculairement au plan yz tel qu'illustré par exemple sur la figure 1A.

Plus particulièrement, sur les figures 2A et 2B, le matériau piézoélectrique 302a du premier transducteur 11a est situé sous la poutre 305a, c'est-à-dire qu'il est situé entre la poutre 305a et la première membrane 12a. Lorsqu'une tension électrique est appliquée au matériau piézoélectrique 302a, il se rétracte et entraîne avec lui la partie de la poutre 305a située au centre de l'anneau que forme le matériau piézoélectrique 302a. Cette partie de la poutre 305a se courbe vers le bas, entraînant avec elle au moins une partie de la zone 123a de la première membrane 12a liée à la poutre 305a. Par conservation de volume, la zone libre 121a de la première membrane 12a, et le cas échéant la zone libre 121b de la deuxième membrane 12b, se déplacent quant à elles à l'opposé du centre de la cavité 13, entraînant alors avec elle le déplacement à l'opposé du centre de la cavité 13 du pion 122a, et le cas échéant du pion 122b.

Sur les figures 2A et 2B, le matériau piézoélectrique 302b du deuxième transducteur 11b est situé au-dessus de la poutre 305b. Lorsqu'une tension électrique est appliquée au matériau piézoélectrique 302b, il se rétracte et entraîne avec lui la partie de la poutre 305b située au centre de l'anneau que forme le matériau piézoélectrique 302b. Cette partie de la poutre 305b se courbe vers le haut, et plus particulièrement vers le centre de la cavité, entraînant avec elle au moins une partie de la zone 123b de la deuxième membrane 12b liée à la poutre 305b. Par conservation de volume, la zone libre 121a de la première membrane 12a, et le cas échéant la zone libre 121b de la deuxième membrane 12b, se déplacent quant à elles à l'opposé du centre de la cavité 13, entraînant alors avec elle le déplacement à l'opposé du centre de la cavité 13 du pion 122a, et le cas échéant du pion 122b.

Sur les figures 2A et 2B, on observe également des ouvertures d'accès pour une connexion électrique des électrodes. Ces ouvertures forment dans ces exemples des via 17. Dans cet exemple, les vias 17 traversent toute l'épaisseur d'une des poutres 305a et 305b.

L'épaisseur e305 de chaque poutre 305a, 305b est mesurée selon une direction perpendiculaire au plan dans lequel s'étend principalement les faces 12e et 12i de chaque membrane 12a, 12b. L'épaisseur e305 est référencée en figure 2A et 2B.

Les poutres 305a et 305b illustrées sur les figures 2A et 2B ont sensiblement la même épaisseur e305, mais peuvent en alternative présenter des épaisseurs différentes entre elles. On obtient ainsi une dissymétrie entre les actionnements que procurent les transducteurs 12a et 12b, qui peut être souhaitable pour certaines applications.

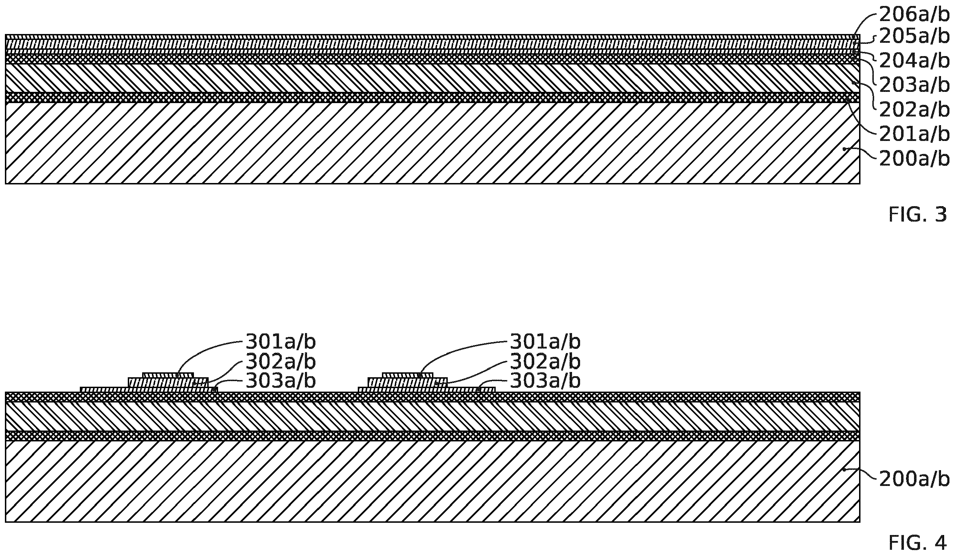

Les figures 2A et 2B illustrent plus particulièrement des modes de réalisation de l'invention qui ont été obtenus par des étapes de dépôt et de gravure pouvant être qualifiées comme ordinaires dans le domaine de la microélectronique. Plus particulièrement, le microsystème électromécanique 1 selon le mode de réalisation illustré sur la figure 2A a été obtenu par la succession d'étapes illustrées par les figures 3 à 6, 7A, 8A, 9A et 10A et le microsystème électromécanique 1 selon le mode de réalisation illustré sur la figure 2B a été obtenu par la succession d'étapes illustrées par les figures 3 à 6, 7B, 8B, 9B et 10B. Ainsi, deux procédés de fabrication sont illustrés qui mènent chacun à l'un des microsystèmes électromécaniques 1 illustrés sur les figures 2A et 2B.

Ces procédés de fabrication ont au moins en commun de comprendre :
- une étape de formation de ce qui est destiné à constituer une portion au moins du premier transducteur électromécanique 11a et la première membrane déformable 12a sur un premier substrat 200a, et
- une étape de formation de ce qui est destiné à constituer une portion au moins du deuxième transducteur électromécanique 11b sur un second substrat 200b, puis
- une étape de formation d'une cavité 13 ouverte sur la première membrane déformable 12a par report du second substrat 200b sur le premier substrat 200a, puis
- une étape de remplissage avec le milieu déformable 14 et de fermeture de la cavité 13, et
- une étape de gravure des premier et second substrats 200a et 200b pour former, respectivement, la face avant et la face arrière des microsystèmes électromécaniques illustrés sur les figures 2A et 2B.

Nous décrivons ci-dessous successivement chacun des procédés de fabrication susmentionnés, en commençant par le procédé de fabrication du microsystème électromécanique 1 tel qu'illustré sur la figure 2A.

La première étape de ce procédé est illustrée sur la figure 3. Elle consiste à fournir un premier substrat 200a sur lequel un empilement de couches s'étend qui peut comprendre successivement, depuis une face du premier substrat 200a :
- une première couche isolante 201a, par exemple à base d'oxyde de silicium, pouvant être déposée par dépôt chimique en phase vapeur assisté par plasma (ou PECVD, pour Plasma-Enhanced Chemical Vapor Déposition en anglais),
- une couche 202a destinée à constituer la poutre 305a du premier transducteur électromécanique 11a, cette couche 202a étant par exemple à base de silicium amorphe et pouvant être déposée par dépôt chimique en phase vapeur (ou CVD pour l'anglais chemical vapor déposition) à pression sous-atmosphérique (ou LPCVD),
- une deuxième couche isolante 203a, par exemple à base d'oxyde de silicium et pouvant être déposée par PECVD,
- une couche 204a destinée à constituer une électrode dite inférieure, par exemple à base de platine et pouvant être déposée par dépôt physique en phase vapeur (ou PVD pour l'anglais physical vapor déposition),
- une couche 205a en un matériau piézoélectrique, par exemple à base de PZT, et pouvant être déposée par un procédé sol gel, et
- une couche 206a destinée à constituer une électrode dite supérieure, par exemple à base de platine et pouvant être déposée par PVD.

La deuxième étape du procédé de fabrication du microsystème électromécanique 1 tel qu'illustré sur la figure 2A est illustrée sur la figure 4. Elle comprend :
- une gravure de la couche 206a de sorte à former l'électrode supérieure 301a du premier transducteur électromécanique 11a,
- une gravure de la couche 205a de sorte à former les éléments piézoélectriques 302a du premier transducteur électromécanique 11a, et
- une gravure de la couche 204a de sorte à former l'électrode inférieure 303a du premier transducteur électromécanique 11a.

Notons que chacune de ces gravures peut être réalisée par lithographie, et préférentiellement par gravure au plasma, ou par voie chimique humide.

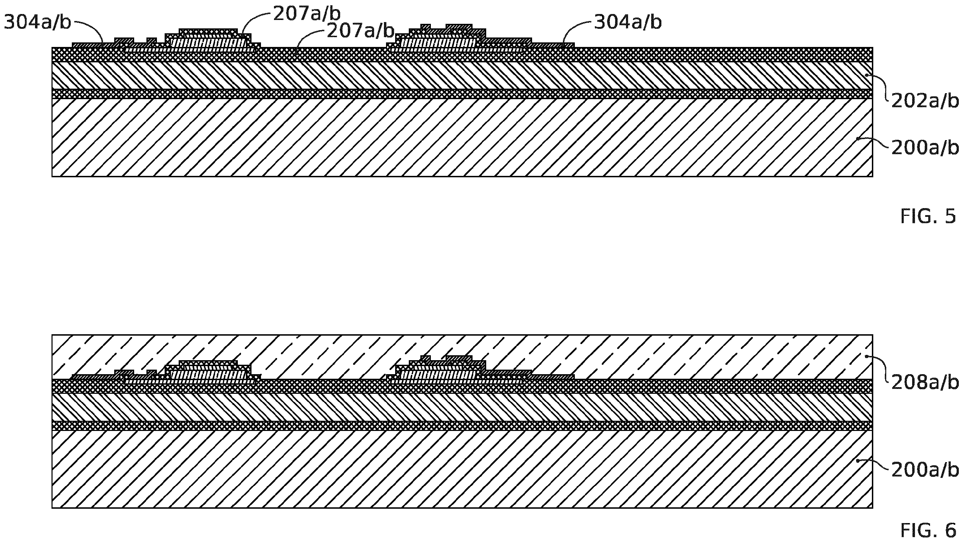

La troisième étape du procédé de fabrication du microsystème électromécanique 1 tel qu'illustré sur la figure 2A est illustrée sur la figure 5. Elle comprend :
- le dépôt d'une couche de passivation 207a, par exemple à base d'oxyde de silicium et/ou de nitrure de silicium, pouvant être déposée par PECVD,
- l'ouverture, à travers la couche de passivation 207a, d'une zone de reprise de contact par électrode, cette ouverture étant réalisée par exemple par lithographie, et préférentiellement par gravure au plasma, ou par voie chimique humide,

- le dépôt d'une couche destinée à constituer une ligne électrique 304a par électrode, la couche étant par exemple à base d'or et pouvant être déposée par PVD, et
- une gravure de la couche précédemment déposée de sorte à former une ligne électrique 304a par électrode, cette gravure étant réalisée par exemple par lithographie, et préférentiellement par gravure au plasma, ou par voie chimique humide.

La quatrième étape du procédé de fabrication du microsystème électromécanique 1 tel qu'illustré sur la figure 2A est illustrée sur la figure 6. Elle comprend le dépôt d'une couche 208a à base d'un polymère et destinée à constituer la première membrane déformable 12a. Cette couche 208a est par exemple déposée par enduction centrifuge (ou spin coating en anglais). Le polymère à base duquel la couche 208a est constituée est par exemple à base de PDMS.

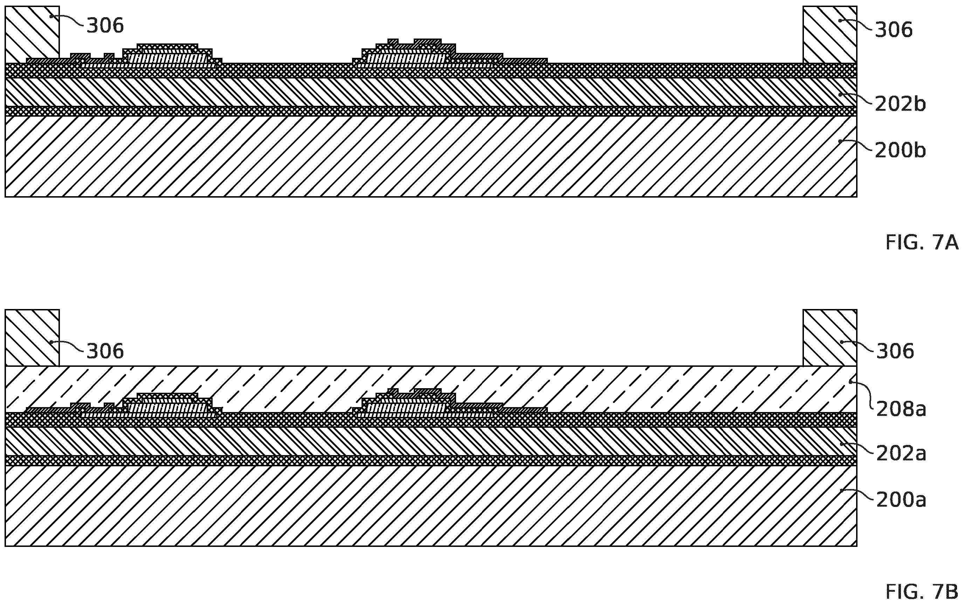

La cinquième étape du procédé de fabrication du microsystème électromécanique 1 tel qu'illustré sur la figure 2A est illustrée sur la figure 7A. Elle comprend la formation d'au moins un espaceur 306 destiné à constituer au moins une partie de la paroi 133 latérale de la cavité 13. La formation du ou des espaceurs peut comprendre le laminage d'un matériau photosensible à base duquel le ou les espaceurs sont constitués, l'insolation, puis le développement du matériau photosensible. Ledit matériau photosensible peut être à base d'un polymère, et notamment à base de Siloxane. Le laminage du matériau photosensible peut comprendre le laminage d'un film sec dudit matériau.

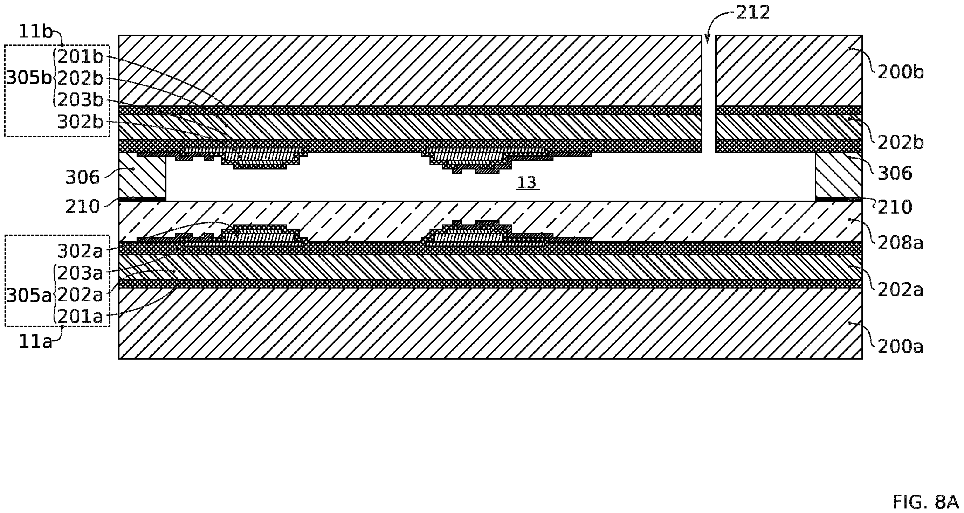

La sixième étape du procédé de fabrication du microsystème électromécanique 1 tel qu'illustré sur la figure 2A est illustrée sur la figure 8A. Selon un mode de réalisation optionnelle, cette étape comprend le dépôt de colle 210 au sommet de chaque espaceur 306, ce dépôt pouvant être réalisé par sérigraphie ou par dispense. Elle comprend la fixation, par exemple le collage, sur le sommet du ou des espaceurs (éventuellement par l'intermédiaire de la colle 210), d'une portion du deuxième transducteur électromécanique 11b sur un second substrat 200b. Cette dernière peut être structurée de sorte à comprendre au moins un évent traversant 212. Dans un mode de réalisation alternatif, selon la nature de l'espaceur, celui-ci peut jouer le rôle de colle. À l'issue de cette sixième étape, la cavité 13 est formée et est ouverte par au moins un évent traversant 212.

Plus particulièrement, ladite portion du deuxième transducteur électromécanique 11b peut avoir été obtenue par dépôt d'un empilement de couches s'étendant sur le second substrat 200b, et plus particulièrement sur sa face destinée à être reportée en vis-à-vis du premier substrat 200a. Cet empilement de couches peut comprendre successivement :
- une première couche isolante 201b, par exemple à base d'oxyde de silicium, pouvant être déposée par dépôt chimique en phase vapeur assisté par plasma (ou PECVD, pour Plasma-Enhanced Chemical Vapor Déposition en anglais),
- une couche 202b destinée à constituer la poutre 305b du deuxième transducteur électromécanique 11b, cette couche 202b étant par exemple à base de silicium amorphe et pouvant être déposée par dépôt chimique en phase vapeur (ou CVD pour l'anglais chemical vapor déposition) à pression sous-atmosphérique (ou LPCVD),
- une deuxième couche isolante 203b, par exemple à base d'oxyde de silicium et pouvant être déposée par PECVD,
- une couche destinée à constituer une électrode dite inférieure, par exemple à base de platine et pouvant être déposée par dépôt physique en phase vapeur (ou PVD pour l'anglais physical vapor déposition),
- une couche en un matériau piézoélectrique, par exemple à base de PZT, et pouvant être déposée par un procédé sol gel, et
- une couche destinée à constituer une électrode dite supérieure, par exemple à base de platine et pouvant être déposée par PVD,
- une gravure de la couche destinée à constituer une électrode dite supérieure de sorte à former l'électrode supérieure 301b du deuxième transducteur électromécanique 11b,
- une gravure de la couche en un matériau piézoélectrique de sorte à former les éléments piézoélectriques 302b du deuxième transducteur électromécanique 11b,
- une gravure de la couche destinée à constituer une électrode dite inférieure de sorte à former l'électrode inférieure 303b du deuxième transducteur électromécanique 11b,
- le dépôt d'une couche de passivation, par exemple à base d'oxyde de silicium et/ou de nitrure de silicium, pouvant être déposée par PECVD,
- l'ouverture, à travers la couche de passivation, d'une zone de reprise de contact par électrode, cette ouverture étant réalisée par exemple par lithographie, et préférentiellement par gravure au plasma, ou par voie chimique humide,
- le dépôt d'une couche destinée à constituer une ligne électrique 304b par électrode, la couche étant par exemple à base d'or et pouvant être déposée par PVD, et
- une gravure de la couche précédemment déposée de sorte à former une ligne électrique 304b par électrode, cette gravure étant réalisée par exemple par lithographie, et préférentiellement par gravure au plasma, ou par voie chimique humide.

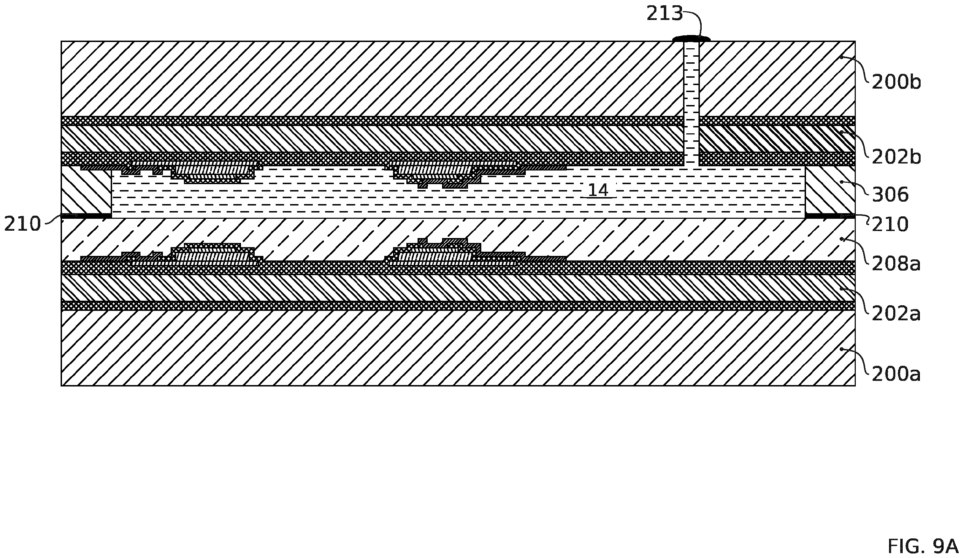

La septième étape du procédé de fabrication du microsystème électromécanique 1 tel qu'illustré sur la figure 2A est illustrée sur la figure 9A. Elle comprend le remplissage, de préférence sous vide, de la cavité 13 avec le milieu déformable 14 tel que décrit ci-dessus, par exemple par dispense à travers l'au moins un évent traversant 212. Elle comprend également la fermeture étanche de l'au moins un évent traversant 212, par exemple par dispense d'un matériau de scellement 213 à l'embouchure de chaque évent traversant 212, le matériau de scellement 213 étant par exemple à base d'une colle époxy.

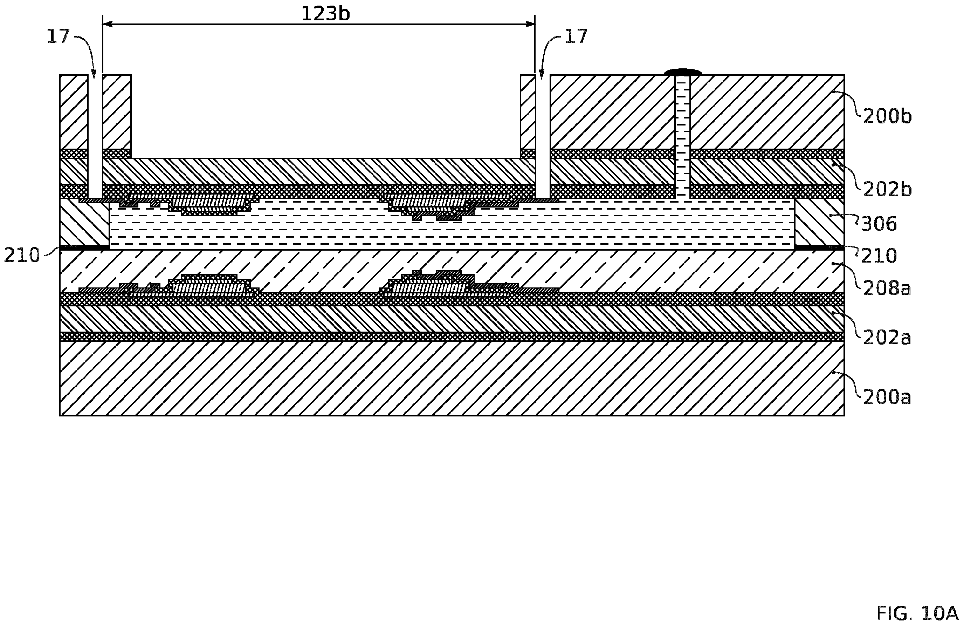

La huitième étape du procédé de fabrication du microsystème électromécanique 1 tel qu'illustré sur la figure 2A est illustrée sur la figure 10A. Elle comprend la gravure du second substrat 200b. Cette gravure peut être réalisée par lithographie, et préférentiellement par gravure au plasma, ou par voie chimique humide. Elle comprend ensuite la gravure de la couche 202b et des couches isolantes 201b, 203b de sorte à former au moins une poutre 305b du deuxième transducteur électromécanique 11b.

La neuvième étape du procédé de fabrication du microsystème électromécanique 1 tel qu'illustré sur la figure 2A est l'étape permettant de l'obtenir. Elle comprend la gravure du premier substrat 200a. Cette gravure peut être réalisée par lithographie, et préférentiellement par gravure au plasma, ou par voie chimique humide. Elle comprend ensuite la gravure de la couche 202a et des couches isolantes 201a, 203a de sorte à former au moins une poutre 305a du premier transducteur électromécanique 11a, à exposer une partie de la première membrane déformable 12a et à constituer tout ou partie du pion 122a et des éventuelles butées latérales 15a.

Notons que, suite aux étapes décrites ci-dessus de fabrication du microsystème électromécanique 1 tel qu'illustré sur la figure 2A, le pion 122a prend la forme d'un empilement s'étendant directement depuis la première membrane déformable 12a à l'opposé de la cavité 13 en présentant successivement le matériau de la couche isolante 203a, le matériau constituant la poutre 305a, le matériau de la couche isolante 201a et le matériau constituant le premier substrat 200a. Notons également que, suite aux étapes décrites ci-dessus de fabrication du microsystème électromécanique 1 tel qu'illustré sur la figure 2A, les éventuelles butées latérales 15a prennent chacune la forme d'un empilement s'étendant, directement ou indirectement, depuis la première membrane déformable 12a à l'opposé de la cavité 13 en présentant successivement le matériau de la couche isolante 203a, le matériau constituant la poutre 305a, le matériau de la couche isolante 201a et le matériau constituant le premier substrat 200a.

Le procédé de fabrication du microsystème électromécanique 1 tel qu'illustré sur la figure 2B est décrit ci-dessous.

Les cinq premières étapes du procédé de fabrication du microsystème 1 tel qu'illustré sur la figure 2B sont identiques aux cinq premières étapes décrites ci-dessus du procédé de fabrication du microsystème 1 tel qu'illustré sur la figure 2A.

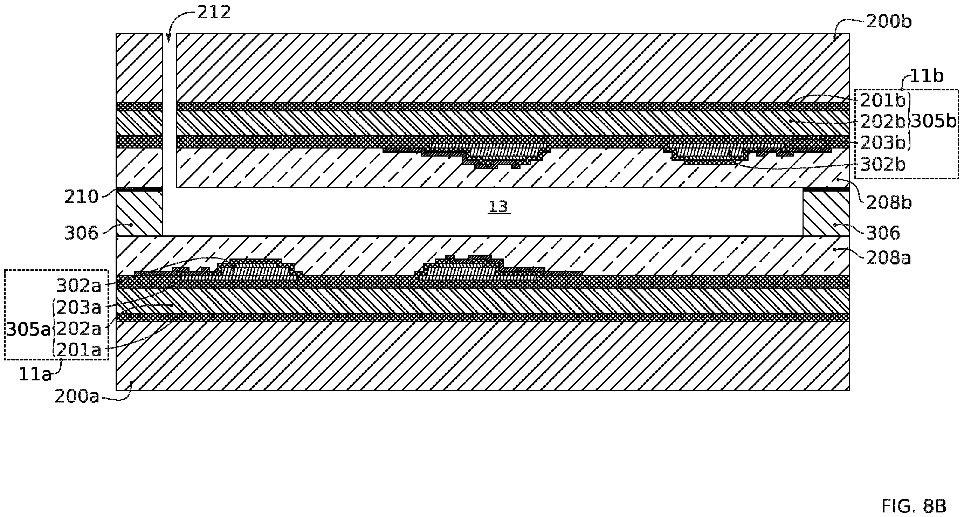

La sixième étape du procédé de fabrication du microsystème électromécanique 1 tel qu'illustré sur la figure 2B est illustrée sur la figure 8B. Selon un mode de réalisation optionnelle, cette étape comprend le dépôt de colle 210 au sommet de chaque espaceur 306, ce dépôt pouvant être réalisé par sérigraphie ou par dispense. Elle comprend la fixation, par exemple le collage, sur le sommet du ou des espaceurs (éventuellement par l'intermédiaire de la colle 210), d'une portion du deuxième transducteur électromécanique 11b sur un second substrat 200b. Cette dernière peut être structurée de sorte à comprendre au moins un évent traversant 212. Dans un mode de réalisation alternatif, selon la nature de l'espaceur, celui-ci peut jouer le rôle de colle. À l'issue de cette sixième étape, la cavité 13 est formée qui est ouverte par au moins un évent traversant 212.

Plus particulièrement, ladite portion du deuxième transducteur électromécanique 11b peut avoir été obtenue par dépôt d'un empilement de couches s'étendant sur le second substrat 200b, et plus particulièrement sur sa face destinée à être reportée en vis-à-vis du premier substrat 200a. Cet empilement de couches peut comprendre successivement :
- une première couche isolante 201b, par exemple à base d'oxyde de silicium, pouvant être déposée par dépôt chimique en phase vapeur assisté par plasma (ou PECVD, pour Plasma-Enhanced Chemical Vapor Déposition en anglais),
- une couche 202b destinée à constituer la poutre 305b du deuxième transducteur électromécanique 11b, cette couche 202b étant par exemple à base de silicium amorphe et pouvant être déposée par dépôt chimique en phase vapeur (ou CVD pour l'anglais chemical vapor déposition) à pression sous-atmosphérique (ou LPCVD),
- une deuxième couche isolante 203b, par exemple à base d'oxyde de silicium et pouvant être déposée par PECVD,
- une couche destinée à constituer une électrode dite inférieure, par exemple à base de platine et pouvant être déposée par dépôt physique en phase vapeur (ou PVD pour l'anglais physical vapor déposition),
- une couche en un matériau piézoélectrique, par exemple à base de PZT, et pouvant être déposée par un procédé sol gel, et
- une couche destinée à constituer une électrode dite supérieure, par exemple à base de platine et pouvant être déposée par PVD,
- une gravure de la couche destinée à constituer une électrode dite supérieure de sorte à former l'électrode supérieure 301b du deuxième transducteur électromécanique 11b,
- une gravure de la couche en un matériau piézoélectrique de sorte à former les éléments piézoélectriques 302b du deuxième transducteur électromécanique 11b,
- une gravure de la couche destinée à constituer une électrode dite inférieure de sorte à former l'électrode inférieure 303b du deuxième transducteur électromécanique 11b,
- le dépôt d'une couche de passivation, par exemple à base d'oxyde de silicium et/ou de nitrure de silicium, pouvant être déposée par PECVD,
- l'ouverture, à travers la couche de passivation, d'une zone de reprise de contact par électrode, cette ouverture étant réalisée par exemple par lithographie, et préférentiellement par gravure au plasma, ou par voie chimique humide,
- le dépôt d'une couche destinée à constituer une ligne électrique 304b par électrode, la couche étant par exemple à base d'or et pouvant être déposée par PVD,
- une gravure de la couche précédemment déposée de sorte à former une ligne électrique 304b par électrode, cette gravure étant réalisée par exemple par lithographie, et préférentiellement par gravure au plasma, ou par voie chimique humide, et
- le dépôt d'une couche 208b à base d'un polymère et destinée à constituer la deuxième membrane déformable 12b. Cette couche 208b est par exemple déposée par enduction centrifuge (ou spin coating en anglais). Le polymère à base duquel la couche 208b est constituée est par exemple à base de PDMS.

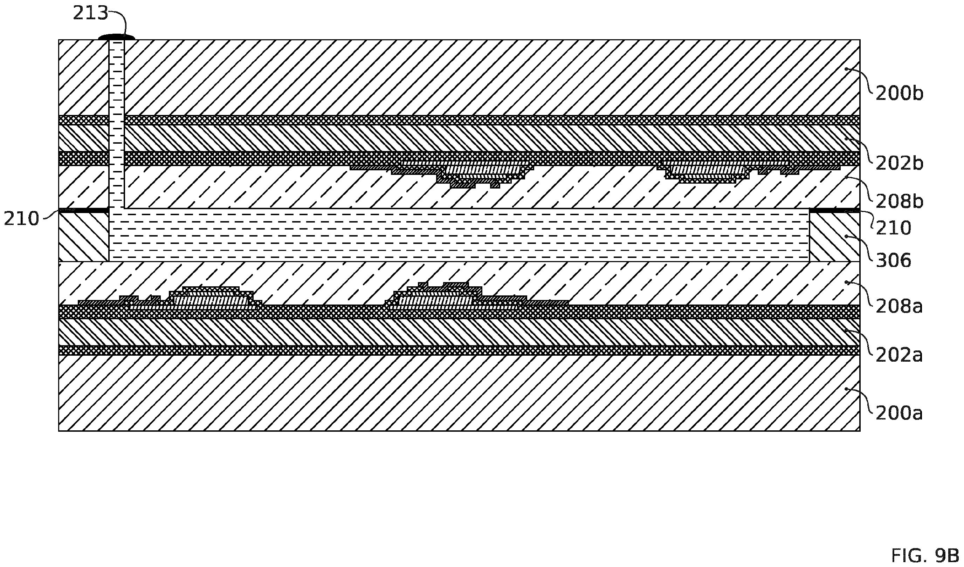

La septième étape du procédé de fabrication du microsystème électromécanique 1 tel qu'illustré sur la figure 2B est illustrée sur la figure 9B. Elle comprend le remplissage, de préférence sous vide, de la cavité 13 avec le milieu déformable 14 tel que décrit ci-dessus, par exemple par dispense à travers l'au moins un évent traversant 212. Elle comprend également la fermeture étanche de l'au moins un évent traversant 212, par exemple par dispense d'un matériau de scellement 213 au moins à l'embouchure de chaque évent traversant 212, le matériau de scellement 213 étant par exemple à base d'une colle époxy.

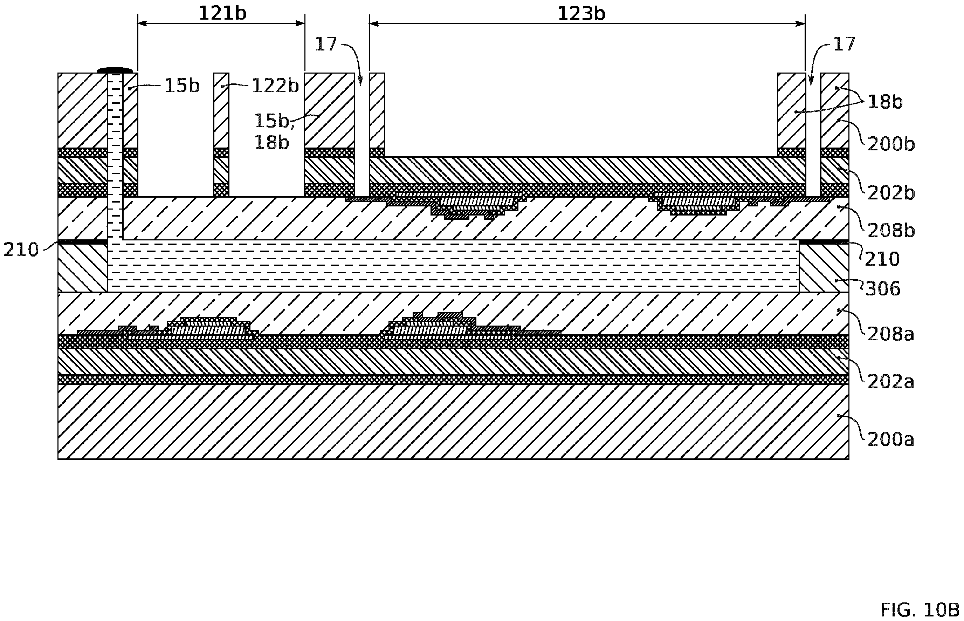

La huitième étape du procédé de fabrication du microsystème électromécanique 1 tel qu'illustré sur la figure 2B est illustrée sur la figure 10B. Elle comprend la gravure du second substrat 200b. Cette gravure peut être réalisée par lithographie, et préférentiellement par gravure au plasma, ou par voie chimique humide. Elle comprend ensuite la gravure de la couche 202b et des couches isolantes 201b, 203b de sorte à former au moins une poutre 305b du deuxième transducteur électromécanique 11b, à exposer une partie de la deuxième membrane déformable 12b et à constituer tout ou partie du pion 122b et des éventuelles butées latérales 15b.

La neuvième étape du procédé de fabrication du microsystème électromécanique 1 tel qu'illustré sur la figure 2B est l'étape permettant de l'obtenir. Elle comprend la gravure du premier substrat 200a. Cette gravure peut être réalisée par lithographie, et préférentiellement par gravure au plasma, ou par voie chimique humide. Elle comprend ensuite la gravure de la couche 202b et des couches isolantes 201b, 203b de sorte à former au moins une poutre 305a du premier transducteur électromécanique 11a, à exposer une partie de la première membrane déformable 12a et à constituer tout ou partie du pion 122a et des éventuelles butées latérales 15a.

Notons que, suite aux étapes décrites ci-dessus de fabrication du microsystème électromécanique 1 tel qu'illustré sur la figure 2B, le pion 122b prend la forme d'un empilement s'étendant directement depuis la deuxième membrane déformable 12b à l'opposé de la cavité 13 en présentant successivement le matériau de la couche isolante 203b, le matériau constituant la poutre 305b, le matériau de la couche isolante 201b et le matériau constituant le deuxième substrat 200b. Notons également que, suite aux étapes décrites ci-dessus de fabrication du microsystème électromécanique 1 tel qu'illustré sur la figure 2A, les éventuelles butées latérales 15b prennent chacune la forme d'un empilement s'étendant, directement ou indirectement, depuis la deuxième membrane déformable 12b à l'opposé de la cavité 13 en présentant successivement le matériau de la couche isolante 203a, le matériau constituant la poutre 305a, le matériau de la couche isolante 201a et le matériau constituant le second substrat 200b.

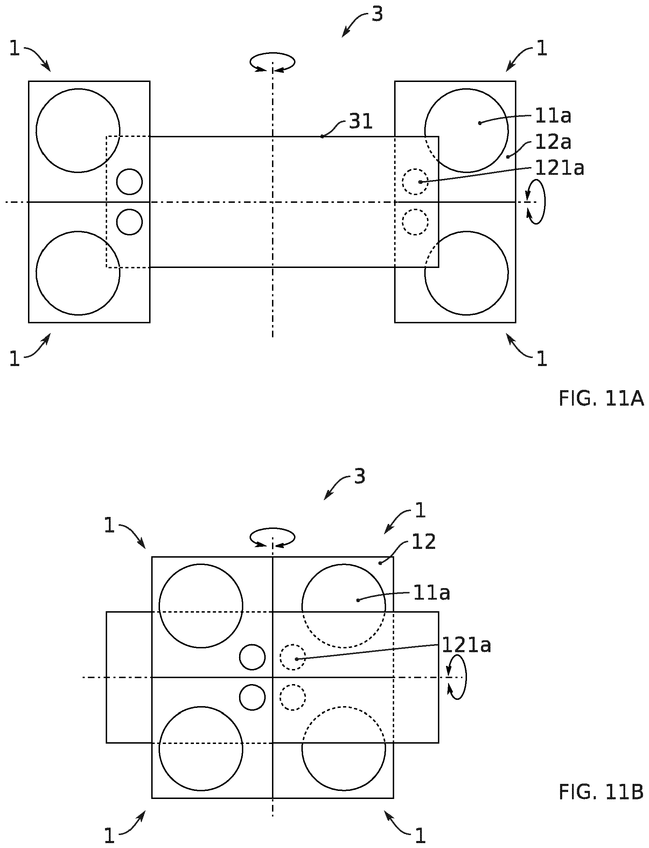

Un autre aspect de l'invention concerne un système opto-électro-mécanique 3 tel qu'illustré sur les figures 11A et 11B. Il peut s'agir d'un microsystème opto-électro-mécanique 3. Chacun des microsystèmes opto-électro-mécaniques 3 illustrés sur ces figures comprend au moins un microsystème électromécanique 1 tel que décrit ci-dessus et au moins un microsystème optique 31. Le microsystème optique 31 peut comprendre un micro-miroir à base de silicium, dont la surface est le cas échéant surmontée d'au moins un miroir. Il peut être monté directement sur le microsystème électromécanique 1 ou y être monté par l'intermédiaire d'un cadre. Il peut présenter des dimensions sensiblement égales à 2 mm x 5 mm et/ou, au maximum, une épaisseur d'environ 700 µm. Les microsystèmes opto-électro-mécaniques 3 tels qu'illustrés comprennent chacun quatre microsystèmes électromécaniques 1 présentant chacun une zone libre 121 agencée en vis-à-vis d'une partie d'un même microsystème optique 31, cette partie lui étant propre et étant de préférence un coin dudit microsystème optique 31 ou un coin de son centre. On obtient ainsi un microsystème opto-électro-mécanique 1 bénéficiant d'une large capacité d'adaptation de son orientation optique.

L'invention n'est pas limitée aux modes de réalisation précédemment décrits et s'étend à tous les modes de réalisation couverts par les revendications.

En particulier, le pion 122a, 122b n'est pas nécessairement fixé au centre de la zone libre 121a, 121b de la membrane déformable 12a, 12b. Un ou plusieurs pions 122a, 122b peuvent être positionnés de manière décentrée sur la zone libre 121a, 121b.

Notamment, d'autres applications que celles décrites ci-dessus sont envisageables. Par exemple, le microsystème électromécanique 1 peut être agencé dans une micropompe, voire dans un système à tableau de micropompes, dans un système haptique, dans un système d'auto-assemblage de composants microélectroniques ou dans un système à membrane vibratoire, et éventuellement acoustique. En outre, il est envisageable que le microsystème électromécanique 1 puisse être adapté à la réalisation d'un mouvement d'engrenage (ou « gear motion » selon la terminologie anglo-saxonne).

## Revendications

1. Microsystème électromécanique (1) comprenant :
• au moins deux transducteurs électromécaniques (11a et 11b) comprenant chacun une partie mobile (111a, 111b) entre une position d'équilibre, hors sollicitation, et une position hors équilibre, sous sollicitation,
• une première membrane déformable (12a),
• une cavité (13) déformable, constituée de parois (131, 132, 133), les parois étant configurées pour contenir hermétiquement un milieu déformable (14) propre à conserver un volume sensiblement constant sous l'action d'un changement de pression externe,
dans lequel au moins une partie de la première membrane déformable (12a) forme au moins une partie d'une première paroi (131) prises parmi lesdites parois (131, 132, 133) de la cavité (13), dans lequel la partie mobile (111a, 111b) de chaque transducteur électromécanique (11a, 11b) est configurée de sorte que son mouvement soit fonction dudit changement de pression externe, et dans lequel ladite au moins une partie de la première membrane déformable (12a) présente au moins une zone libre (121a) de se déformer en fonction dudit changement de pression externe, le microsystème électromécanique (1) étant en outre tel que :
• un premier transducteur électromécanique (11a) forme une partie de ladite première paroi (131) de la cavité (13), et
• un deuxième transducteur électromécanique (11b) forme au moins une partie de la paroi (132) opposée à ladite première paroi (131) de la cavité (13),
le microsystème électromécanique (1) étant **caractérisé en ce que** la partie mobile (111a, 111b) de chaque transducteur électromécanique (11a, 11b) est en outre configurée de sorte que ledit changement de pression externe soit fonction dudit mouvement de la partie mobile (111a, 111b) de chaque transducteur électromécanique (11a, 11b) et **en ce que** la zone libre (121a, 121b) de la première membrane déformable (12a) est configurée pour coopérer avec au moins un organe externe (2) via au moins un pion (122a) fixé sur ladite zone libre (121a).

2. Microsystème électromécanique (1) selon la revendication précédente, dans lequel
• la partie mobile (111a, 111b) de chaque transducteur électromécanique (11a, 11b) est configurée de sorte que sa sollicitation ou une augmentation de pression externe induise son mouvement vers l'extérieur de la cavité (13), ou
• la partie mobile (111a, 111b) de chaque transducteur électromécanique (11a, 11b) est configurée de sorte que sa sollicitation ou une diminution de pression externe induise son mouvement vers l'intérieur de la cavité (13).

3. Microsystème électromécanique (1) selon l'une quelconque des revendications précédentes, dans lequel le premier transducteur électromécanique (11a) s'étend sur la première membrane déformable (12a).

4. Microsystème électromécanique (1) selon l'une quelconque des revendications précédentes, dans lequel le premier transducteur électromécanique (11a) s'étend autour de la zone libre (121a) de la première membrane déformable (12a).

5. Microsystème électromécanique (1) selon l'une quelconque des revendications 1 à 3, dans lequel le premier transducteur électromécanique (11a) s'étend dans une zone pleine disjointe de la zone libre (121a) de la première membrane déformable (12a).

6. Microsystème électromécanique (1) selon l'une quelconque des revendications précédentes, comprenant en outre une deuxième membrane déformable (12b) dont au moins une partie forme au moins une partie de la paroi (132) opposée à ladite première paroi (131) de la cavité (13) et dans lequel ladite au moins une partie de la deuxième membrane déformable (12b) présente au moins une zone libre (121b) de se déformer en fonction dudit changement de pression externe.

7. Microsystème électromécanique (1) selon la revendication précédente, dans lequel le deuxième transducteur électromécanique (11b) s'étend sur la deuxième membrane déformable (12b).

8. Microsystème électromécanique (1) selon l'une quelconque des deux revendications précédentes, dans lequel le deuxième transducteur électromécanique (11b) s'étend autour de la zone libre (121b) de la deuxième membrane déformable (12b).

9. Microsystème électromécanique (1) selon l'une quelconque des revendications 6 et 7, dans lequel le deuxième transducteur électromécanique (11b) s'étend dans une zone pleine disjointe de la zone libre (121b) de la deuxième membrane déformable (12b).

10. Microsystème électromécanique (1) selon l'une quelconque des revendications précédentes, dans lequel le pion (122a, 122b) est fixé au centre de la zone libre (121a, 121b) de la membrane déformable (12a, 12b) sur laquelle il est fixé.

11. Microsystème électromécanique (1) selon l'une quelconque des revendications précédentes, dans lequel chaque membrane déformable (12a, 12b) est configurée de sorte que sa zone libre (121a, 121b) est capable de se déformer avec une amplitude d'au moins 50 µm, voire d'environ 100 µm, selon une direction perpendiculaire au plan dans lequel elle s'étend principalement lorsqu'elle est au repos.

12. Microsystème électromécanique (1) selon l'une quelconque des revendications précédentes, dans lequel la partie mobile (111a, 111b) de chaque transducteur électromécanique (11a, 11b) présente une surface au moins deux fois supérieure à une surface de la zone libre (121a, 121b) d'au moins une membrane déformable (12a, 12b).

13. Système opto-électro-mécanique (3) comprenant au moins un microsystème électromécanique (1) selon l'une quelconque des revendications précédentes et au moins un microsystème optique (31), dans lequel ledit au moins un microsystème optique (31) comprend au moins un miroir, de préférence à base de silicium, le système opto-électro-mécanique (3) étant configuré de sorte à ce que le mouvement de la partie mobile (111a, 111b) de chaque transducteur électromécanique (11a, 11b) provoque un déplacement de l'au moins un miroir.

## Patentansprüche

1. Elektromechanisches Mikrosystem (1), das Folgendes umfasst:
• mindestens zwei elektromechanische Wandler (11a und 11b), die jeweils einen Abschnitt (111a, 111b) umfasst, der zwischen einer Gleichgewichtsposition, nicht unter Belastung, und einer Ungleichgewichtsposition, unter Belastung, beweglich ist,
• eine erste verformbare Membran (12a),
• einen verformbaren Hohlraum (13), der durch Wände (131, 132, 133) ausgebildet wird, wobei die Wände dazu konfiguriert sind, ein verformbares Medium (14) hermetisch zu enthalten, das dazu geeignet ist, unter der Wirkung einer Änderung des Außendrucks ein im Wesentlichen konstantes Volumen aufrechtzuerhalten,
wobei mindestens ein Abschnitt der ersten verformbaren Membran (12a) mindestens einen Abschnitt einer ersten Wand (131) bildet, die aus den Wänden (131, 132, 133) des Hohlraums (13) ausgewählt wird, wobei der bewegliche Abschnitt (111a, 111b) jedes elektromechanischen Wandlers (11a, 11b) derart konfiguriert ist, dass seine Bewegung von der Änderung des Außendrucks abhängt, und wobei der mindestens eine Abschnitt der ersten verformbaren Membran (12a) mindestens einen Bereich (121a) aufweist, der in Abhängigkeit von der Änderung des Außendrucks frei verformbar ist, wobei das elektromechanische Mikrosystem (1) ferner derart ist, dass:
• ein erster elektromechanischer Wandler (11a) einen Abschnitt der ersten Wand (131) des Hohlraums (13) bildet, und
• ein zweiter elektromechanischer Wandler (11b) mindestens einen Abschnitt der Wand (132) gegenüber der ersten Wand (131) des Hohlraums (13) bildet,
wobei das elektromechanische Mikrosystem (1) **dadurch gekennzeichnet ist, dass** der bewegliche Abschnitt (111a, 111b) jedes elektromechanischen Wandlers (11a, 11b) ferner derart konfiguriert ist, dass die Änderung des Außendrucks von der Bewegung des beweglichen Abschnitts (111a, 111b) jedes elektromechanischen Wandlers (11a, 11b) abhängt, und dadurch, dass der freie Bereich (121a, 121b) der ersten verformbaren Membran (12a) dazu konfiguriert ist, über mindestens einen an dem freien Bereich (121a) befestigten Stift (122a) mit mindestens einem externen Element (2) zusammenzuwirken.

2. Elektromechanisches Mikrosystem (1) nach dem vorhergehenden Anspruch, wobei
• der bewegliche Abschnitt (111a, 111b) jedes elektromechanischen Wandlers (11a, 11b) derart konfiguriert ist, dass seine Belastung oder ein Anstieg des Außendrucks seine Bewegung in Richtung der Außenseite des Hohlraums (13) induziert, oder
• der bewegliche Abschnitt (111a, 111b) jedes elektromechanischen Wandlers (11a, 11b) derart konfiguriert ist, dass seine Belastung oder ein Abfall des Außendrucks seine Bewegung in Richtung des Inneren des Hohlraums (13) induziert.

3. Elektromechanisches Mikrosystem (1) nach einem der vorhergehenden Ansprüche, wobei sich der erste elektromechanische Wandler (11a) über die erste verformbare Membran (12a) erstreckt.

4. Elektromechanisches Mikrosystem (1) nach einem der vorhergehenden Ansprüche, wobei sich der erste elektromechanische Wandler (11a) um den freien Bereich (121a) der ersten verformbaren Membran (12a) erstreckt.

5. Elektromechanisches Mikrosystem (1) nach einem der Ansprüche 1 bis 3, wobei sich der erste elektromechanische Wandler (11a) in einem festen Bereich erstreckt, der vom freien Bereich (121a) der ersten verformbaren Membran (12a) getrennt ist.

6. Elektromechanisches Mikrosystem (1) nach einem der vorhergehenden Ansprüche, das ferner eine zweite verformbare Membran (12b) umfasst, von der mindestens ein Abschnitt mindestens einen Abschnitt der Wand (132) gegenüber der ersten Wand (131) des Hohlraums (13) bildet, und wobei der mindestens eine Abschnitt der zweiten verformbaren Membran (12b) mindestens einen freien Bereich (121b) aufweist, der sich in Abhängigkeit von der Änderung des Außendrucks verformt.

7. Elektromechanisches Mikrosystem (1) nach dem vorhergehenden Anspruch, wobei sich der zweite elektromechanische Wandler (11b) über die zweite verformbare Membran (12b) erstreckt.

8. Elektromechanisches Mikrosystem (1) nach einem der vorhergehenden Ansprüche, wobei sich der zweite elektromechanische Wandler (11b) um den freien Bereich (121b) der zweiten verformbaren Membran (12b) erstreckt.

9. Elektromechanisches Mikrosystem (1) nach einem der Ansprüche 6 und 7, wobei sich der zweite elektromechanische Wandler (11b) in einem festen Bereich erstreckt, der vom freien Bereich (121b) der zweiten verformbaren Membran (12b) getrennt ist.

10. Elektromechanisches Mikrosystem (1) nach einem der vorhergehenden Ansprüche, wobei der Stift (122a, 122b) in der Mitte des freien Bereichs (121a, 121b) der verformbaren Membran (12a, 12b) befestigt ist, an der er befestigt ist.

11. Elektromechanisches Mikrosystem (1) nach einem der vorhergehenden Ansprüche, wobei jede verformbare Membran (12a, 12b) derart konfiguriert ist, dass ihr freier Bereich (121a, 121b) dazu in der Lage ist, sich mit einer Amplitude von mindestens 50 um, möglicherweise von etwa 100 um, in einer Richtung senkrecht zu der Ebene zu verformen, in der er sich überwiegend erstreckt, wenn sie sich im Ruhezustand befindet.

12. Elektromechanisches Mikrosystem (1) nach einem der vorhergehenden Ansprüche, wobei der bewegliche Abschnitt (111a, 111b) jedes elektromechanischen Wandlers (11a, 11b) eine Oberfläche aufweist, die mindestens doppelt so groß ist wie eine Oberfläche des freien Bereichs (121a, 121b) mindestens einer verformbaren Membran (12a, 12b).

13. Optoelektromechanisches System (3), das mindestens ein elektromechanisches Mikrosystem (1) nach einem der vorhergehenden Ansprüche und mindestens ein optisches Mikrosystem (31) umfasst, wobei das mindestens eine optische Mikrosystem (31) mindestens einen Spiegel, vorzugsweise auf Siliziumbasis, umfasst, wobei das optoelektromechanische System (3) derart konfiguriert ist, dass die Bewegung des beweglichen Abschnitts (111a, 111b) jedes elektromechanischen Wandlers (11a, 11b) eine Verschiebung mindestens eines Spiegels bewirkt.

## Claims

1. An electromechanical microsystem (1) comprising:
• at least two electromechanical transducers (11a and 11b) each comprising a portion (111a, 111b) movable between a balance position, off-load, and an out-of-balance position, under load,
• a first deformable diaphragm (12a),
• a deformable cavity (13), formed by walls (131, 132, 133), the walls being configured to hermetically contain a deformable medium (14) capable of keeping a substantially constant volume under the action of a change in the external pressure,
wherein at least one portion of the first deformable diaphragm (12a) forms at least one portion of a first wall (131) selected amongst said walls (131, 132, 133) of the cavity (13), wherein the movable portion (111a, 111b) of each electromechanical transducer (11a, 11b) is configured so that its movement depends on said change in the external pressure, and wherein said at least one portion of the first deformable diaphragm (12a) has at least one area (121a) freely deformable as a function of said change in the external pressure, the electromechanical microsystem (1) being further such that:
• a first electromechanical transducer (11a) forms a portion of said first wall (131) of the cavity (13), and
• a second electromechanical transducer (11b) forms at least one portion of the wall (132) opposite to said first wall (131) of the cavity (13),
the electromechanical microsystem (1) being **characterised in that** the movable portion (111a, 111b) of each electromechanical transducer (11a, 11b) is further configured so that said external pressure change depends on said movement of the movable portion (111a , 111b) of each electromechanical transducer (11a, 11b) and **in that** the free area (121a, 121b) of the first deformable diaphragm (12a) is configured to cooperate with at least one external member (2) via at least one pin (122a) fastened on said free area (121a).

2. The electromechanical microsystem (1) according to the preceding claim, wherein
• the movable portion (111a, 111b) of each electromechanical transducer (11a, 11b) is configured so that its loading or an increase in the external pressure induces its movement towards the outside of the cavity (13), or
• the movable portion (111a, 111b) of each electromechanical transducer (11a, 11b) is configured so that its loading or a decrease in the external pressure induces its movement towards the inside of the cavity (13).

3. The electromechanical microsystem (1) according to any one of the preceding claims, wherein the first electromechanical transducer (11a) extends over the first deformable diaphragm (12a).

4. The electromechanical microsystem (1) according to any one of the preceding claims, wherein the first electromechanical transducer (11a) extends around the free area (121a) of the first deformable diaphragm (12a).

5. The electromechanical microsystem (1) according to any one of claims 1 to 3, wherein the first electromechanical transducer (11a) extends in a solid area separate from the free area (121a) of the first deformable diaphragm (12a).

6. The electromechanical microsystem (1) according to any one of the preceding claims, further comprising a second deformable diaphragm (12b) at least one portion of which forms at least one portion of the wall (132) opposite to said first wall (131) of the cavity (13) and wherein said at least one portion of the second deformable diaphragm (12b) has at least one free area (121b) adapted to be deformed as a function of said change in the external pressure.

7. The electromechanical microsystem (1) according to the preceding claim, wherein the second electromechanical transducer (11b) extends over the second deformable diaphragm (12b).

8. The electromechanical microsystem (1) according to any one of the preceding two claims, wherein the second electromechanical transducer (11b) extends around the free area (121b) of the second deformable diaphragm (12b).

9. The electromechanical microsystem (1) according to any one of claims 6 and 7, wherein the second electromechanical transducer (11b) extends in a solid area separate from the free area (121b) of the second deformable diaphragm (12b).

10. The electromechanical microsystem (1) according to any one of the preceding claims, wherein the pin (122a, 122b) is fastened at the centre of the free area (121a, 121b) of the deformable diaphragm (12a, 12b) on which it is fastened.

11. The electromechanical microsystem (1) according to any one of the preceding claims, wherein each deformable diaphragm (12a, 12b) is configured so that its free area (121a, 121b) could be deformed with an amplitude of at least 50 um, or possibly of about 100 um, according to a direction perpendicular to the plane in which it primarily extends when it is at rest.

12. The electromechanical microsystem (1) according to any one of the preceding claims, wherein the movable portion (111a, 111b) of each electromechanical transducer (11a, 11b) has a surface at least twice as large as a surface of the free area (121a, 121b) of at least one deformable diaphragm (12a, 12b).

13. An opto-electro-mechanical system (3) comprising at least one electromechanical microsystem (1) according to any one of the preceding claims and at least one optical microsystem (31), wherein said at least one optical microsystem (31) comprises at least one mirror, preferably silicon-based, the opto-electro-mechanical system (3) being configured so that the movement of the movable portion (111a, 111b) of each electromechanical transducer (11a, 11b) causes a displacement of the at least one mirror.
